# EUROPÄISCHE PATENTSCHRIFT

(11) **EP 0 432 189 B1**
(45) Veröffentlichungstag und Bekanntmachung des Hinweises auf die Patenterteilung: **21.09.1994**
(21) Anmeldenummer: 89909544.2
(22) Anmeldetag: 01.09.1989
(51) Int. Cl.: G01R 31/28, H01J 37/00, G06F 11/00, G01R 31/318

(54) **VERFAHREN UND ANORDNUNG ZUR MESSUNG DES ZUSTANDS UND/ODER ZEITLICHEN VERLAUFS EINES SIGNALS**
PROCESS AND DEVICE FOR MEASURING STATES AND VARIATIONS OVER TIME OF A SIGNAL
PROCEDE ET DISPOSITIF POUR MESURER UN ETAT ET/OU DES VARIATIONS D'UN SIGNAL DANS LE TEMPS

(30) Priorität: 01.09.1988 DE 3829770
(43) Veröffentlichungstag der Anmeldung: 19.06.1991
(73) Patentinhaber: Brust, Hans-Detlef, D-66125 Saarbrücken (DE)
(72) Erfinder: Brust, Hans-Detlef, D-66125 Saarbrücken (DE)
(74) Vertreter: Münich, Wilhelm, Dr.
(86) Internationale Anmeldenummer: DE8900570
(87) Internationale Veröffentlichungsnummer: WO9002955

(56) Entgegenhaltungen:
- DE-A- 2 842 279
- DE-C- 3 523 713
- US-A- 4 220 853
- US-A- 4 223 220

## Beschreibung

### Technisches Gebiet

Die Erfindung bezieht sich auf ein Verfahren zur asynchronen Messung von Signalverläufen an einem oder mehreren Meßpunkten einer Probe sowie auf eine Anordnung zur Durchführung des Verfahrens.

### Stand der Technik

Die Überprüfung der Funktionsweise hochintegrierter Schaltungen erfolgt üblicherweise in rechnergesteuerten Testsystemen, in denen die vorhandenen Fehler durch Analyse der an den Ausgängen der untersuchten Schaltung in Abhängigkeit von den jeweils eingespeisten Bitmustern gemessenen Spannungspegel zwar erkannt, aber nur sehr schwer lokalisiert werden können. Deshalb müssen insbesondere während der Entwicklungsphase zusätzliche Messungen im Innern hochintegrierter Schaltungen durchgeführt werden.

Als für diese Zwecke besonders geeignet, haben sich die in allen Bereichen der Entwicklung und Fertigung mikroelektronischer Bauelemente eingesetzten Korpuskularstrahl-Meßverfahren und hier wieder besonders die Elektronenstrahl-Meßtechnik herausgestellt. Mit Hilfe dieser Meßtechniken läßt sich beispielsweise die elektrische Potentialverteilung in integrierten Schaltungen abbilden (hier sind insbesondere die dem Fachmann unter der Bezeichnung "Voltage Coding" bzw. "Logic-State Mapping" bekannten Verfahren zu nennen) oder der zeitliche Potentialverlauf an einem einzelnen Knotenpunkt bestimmen ("Waveform-Messung"). Eine Zusammenfassung der zur Zeit gewöhnlich eingesetzten Testverfahren der Elektronenstrahl-Meßtechnik ist in der Veröffentlichung "Electron Beam Testing" von E. Wolfgang (Zeitschrift "Microelectronic Engineering", Band 4, 1986, Seiten 77 - 106) wiedergegeben. Von diesem Stand der Technik ausgehend wurde der Oberbegriff des Anspruchs 1 der vorliegenden Erfindung gewählt. Ein weiteres Meßverfahren der Elektronenstrahl-Meßtechnik ist dabei die sogenannte Waveform-Messung, die ausführlich in der Veröffentlichung "Electron Beam Testing: Methods and Applications" von H.-P. Feuerbaum (Zeitschrift "Scanning", Band 5, 1983, Seiten 14 - 24) insbesondere auf den Seiten 12 bis 14 beschrieben ist und mit deren Hilfe der Spannungsverlauf an einem Meßpunkt einer Probe gemessen werden kann.

Bei der Waveform-Messung richtet man einen fein fokussierten Primärelektronenstrahl auf die zu untersuchende Meßstelle der integrierten Schaltung. Die dort auftreffenden Primärelektronen lösen aus der Probenoberfläche Sekundärelektronen aus, die durch die elektrischen Potentiale auf der Probenoberfläche beeinflußt werden. Diese Beeinflussung äußert sich in einem Sekundärelektronenstrom, der vom Potential am Meßort abhängt, bzw. in einer Energieverschiebung der Sekundärelektronen, die ebenfalls vom elektrischen Potential am Meßort bestimmt wird und mit Hilfe eines Energiespektrometers gemessen werden kann. Diesen Effekt bezeichnet man als Potentialkontrast. Da die zur Registrierung der Sekundärelektronen erforderlichen Detektoren gewöhnlich nur eine relativ geringe Bandbreite von einigen MHz aufweisen, muß zur Erzielung einer hohen Zeitauflösung ein Abtastverfahren eingesetzt werden, bei dem der zeitliche Verlauf des Signals am Meßort ähnlich wie bei einem Sampling-Oszilloskop mit kurzen Elektronenimpulsen auf ein Triggersignal hin abgetastet wird. Da jeder Primärelektronenimpuls nur sehr wenige Elektronen enthalten kann, wird zur Erzielung eines ausreichenden Signal-Rausch-Verhältnisses über die Abtastwerte aus sehr vielen Meßzyklen gemittelt.

Da jeder Triggerimpuls einen Primärelektronenimpuls auslöst, das Triggersignal aber kaum beeinflußt werden kann, muß die Erzeugung der Primärelektronenimpulse sehr breitbandig ausgelegt sein. Dies stößt allerdings auf erhebliche Probleme, wenn man zur Erzielung einer hohen Zeitauflösung mit sehr kurzen Primärelektronenimpulsen arbeiten möchte.

### Darstellung der Erfindung

Der Erfindung liegt die Aufgabe zugrunde, Triggerung und Primärimpulserzeugung zu entkoppeln und dadurch den Einsatz schmalbandiger Systeme zur Erzeugung auch sehr kurzer Primärimpulse zu ermöglichen.

Diese Aufgabe wird erfindungsgemäß durch ein Verfahren nach Patentanspruch 1 und durch eine Anordnung nach Patentanspruch 16 gelöst.

Die oben bereits erwähnte Veröffentlichung "Electron Beam Testing: Methods and Applications" von H.-P. Feuerbaum (Zeitschrift "Scanning, Band 5, 1983, Seiten 14 bis 24) beschreibt die sogenannte Waveform-Messung, bei der der Spannungsverlauf an einem Meßpunkt einer Probe gemessen wird. Ausgehend von diesem Stand der Technik wurde der Oberbegriff des Anspruchs 16 gewählt.

Der mit der Erfindung erzielbare Vorteil besteht insbesondere darin, daß sich speziell ausgebildete schmalbandige Systeme zur Erzeugung von sehr kurzen Primärimpulsen einsetzen lassen. Dadurch läßt sich mit geringem Aufwand eine Messung von Signalverläufen mit sehr hoher Zeitauflösung vornehmen. Darüberhinaus wird gegenüber den aus dem Stand der Technik bekannten Verfahren auch die Empfindlichkeit gegen Störungen (etwa durch Aufladungen oder Kontamination) verringert. Außerdem lassen sich nicht nur periodische sondern auch nur statistisch wiederkehrende Signale messen.

Während die Ansprüche 2 bis 15 bevorzugte Weiterbildungen des Verfahrens nach Anspruch 1 betreffen, sind die Ansprüche 17 bis 30 auf Ausgestaltungen der Vorrichtung zur Durchführung des Verfahrens gerichtet.

### Kurze Beschreibung der Zeichnung

Die Erfindung wird im folgenden anhand der Zeichnungen erläutert. Dabei zeigt:
- Fig. 1: das Arbeitsprinzip des herkömmlichen Verfahrens nach dem Stand der Technik anhand eines Zeitdiagramms einiger bei diesem Verfahren auftretender Signale,
- Fig. 2: das Arbeitsprinzip des erfindungsgemäßen Verfahrens anhand eines Zeitdiagramms einiger bei diesem Verfahren auftretender Signale,
- Fig. 3: eine Anordnung zur Durchführung des erfindungsgemäßen Verfahrens,
- Fig. 4: eine Meßwertverarbeitungsanordnung, wie sie in der Anordnung nach Fig. 3 eingesetzt werden kann,
- Fig. 5: eine Ausgestaltung der Primärstrahlquelle, wie sie in der Anordnung nach Fig. 3 eingesetzt werden kann,
- Fig. 6: eine Ausgestaltung der Meßverarbeitungsanordnung für die Multisampling-Variante des erfindungsgemäßen Verfahrens
- Fig. 7: eine Erweiterung der Anordnung nach Fig. 3 zur Durchführung der Multikoinzidenz-Variante des erfindungsgemäßen Verfahrens und
- Fig. 8: das Arbeitsprinzip der Preselektions-Variante des erfindungsgemäßen Verfahrens anhand eines Zeitdiagramms einiger auftretender Signale.

In den Figuren sind jeweils gleiche Signale bzw. Schaltungsteile mit den gleichen Bezugszeichen gekennzeichnet.

### Darstellung von Ausführungsbeispielen

Obwohl sich die folgenden Ausführungsbeispiele auf ein Elektronenstrahl-Meßgerät beziehen, ist die Erfindung so zu verstehen, daß anstelle von Elektronen auch Ionen oder andere Korpuskeln verwendet werden können und zwar sowohl als Primärkorpuskeln als auch als Sekundärkorpuskeln. Ebenso ist es möglich, daß anstelle der Primär- bzw. Sekundärkorpuskeln eine Strahlung, wie z.B. Laser- oder Röntgenstrahlung tritt.

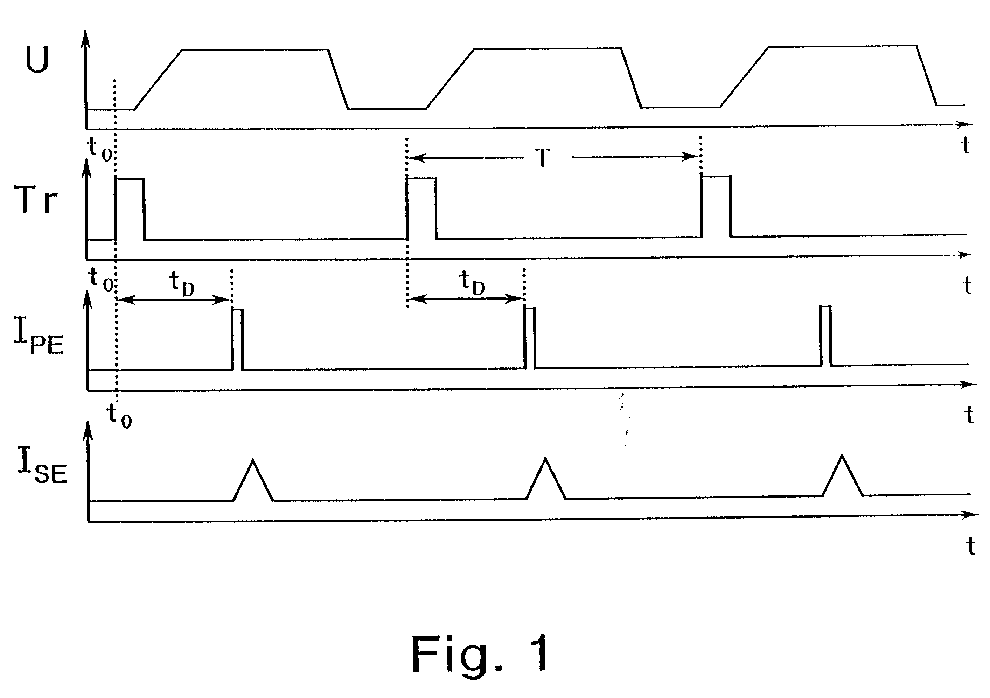

Fig. 1 verdeutlicht das Arbeitsprinzip der herkömmlichen Waveform-Messung nach dem Stand der Technik, wie sie beispielsweise in der zitierten Veröffentlichung von H.-P. Feuerbaum beschrieben ist. Der mit der Periodendauer T periodisch wiederkehrende Signalverlauf U soll gemessen werden. Dazu muß in der zu untersuchenden Probe oder deren Ansteuerung ein Triggersignal Tr erzeugt werden, das das Auftreten des zu messenden Vorganges einleitet und anzeigt. Auf einen solchen Triggerimpuls hin wird dann nach einer Verzögerungszeit t_{D} ein Primärelektronenimpuls erzeugt, was zu einem pulsförmigen Primärelektronenstrom I_{PE} führt. Jeder Primärelektronenimpuls erzeugt einen Sekundärelektronenimpuls, so daß ein entsprechender pulsförmiger Sekundärelektronenstrom I_{SE} entsteht. Die geringe Zeitverschiebung zwischen Primär- und Sekundärelektronenimpulsen ist dabei auf die Laufzeit der Elektronen zwischen Elektronenquelle und Probe bzw. zwischen Probe und Detektor zurückzuführen. Die erreichbare Zeitauflösung wird bei diesem Verfahren nur noch durch die Breite der Primärelektronenimpulse aber nicht mehr durch die Bandbreite des Detektionssystems, mit dem der Sekundärelektronenstrom registriert wird, bestimmt. Durch langsame Verschiebung des Zeitpunktes, zu dem ein Primärelektronenimpuls erzeugt wird, also durch Variation der Verzögerungszeit t_{D}, kann der gesamte interessierende Signalverlauf des Signals U abgetastet werden. Die Geschwindigkeit, mit der die Zeitverzögerung t_{D} verändert wird, bestimmt dabei, über wieviele Abtastwerte bzw. Meßzyklen pro Abtastzeitpunkt gemittelt wird.

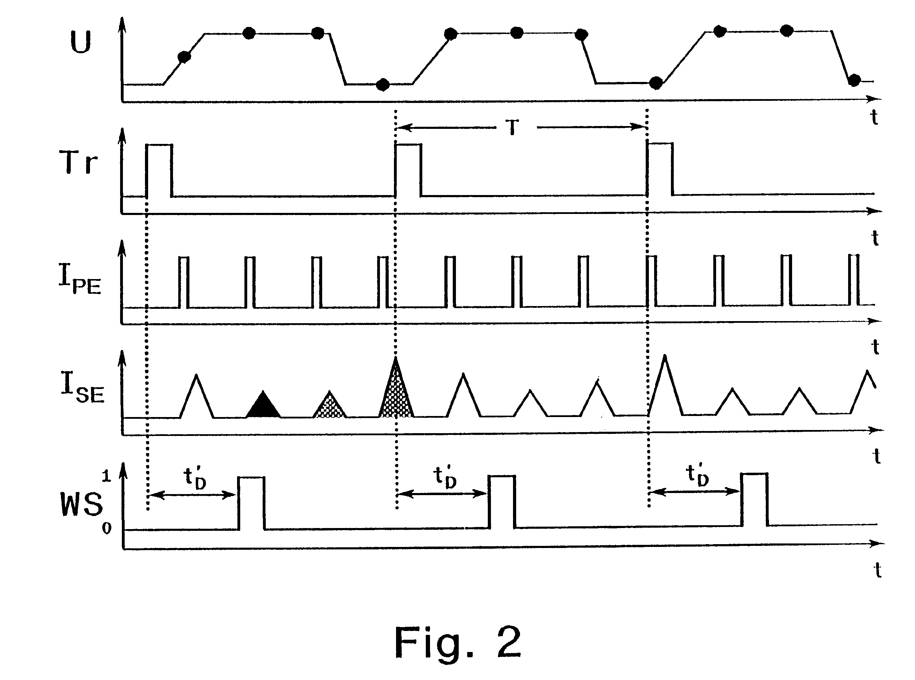

Demgegenüber verdeutlicht Fig. 2 die Wirkungsweise des erfindungsgemäßen Verfahrens. Der zu messende Signalverlauf U und das Triggersignal Tr sind dabei - weil sie vom zu untersuchenden Vorgang nicht aber vom jeweiligen Meßverfahren abhängen - mit Fig. 1 identisch. Dagegen erfolgt beim erfindungsgemäßen Verfahren die Erzeugung der Primärelektronenimpulse völlig unabhängig vom zu messenden Signalverlauf U bzw. zum dazu synchronen Triggersignal Tr. Wann und wie oft die Primärelektronenimpulse erzeugt werden, ist dabei für das Verfahren prinzipiell beliebig, doch ist es vorteilhaft, wenn die Impulse mit konstanter Wiederholfrequenz erzeugt werden, da sich dann schmalbandige Systeme zur Erzeugung der Primärelektronenimpulse einsetzen lassen. Daher wurde auch ein solcher Fall in Fig. 1 angenommen. Entsprechend weisen sowohl der Primärelektronen- I_{PE} als auch der Sekundärelektronenstrom I_{SE} periodische Impulse mit konstantem Abstand auf. Mit diesen Impulsen wird der Signalverlauf U an den durch Punkte gekennzeichneten (in diesem speziellen Fall äquidistanten) Zeitpunkten abgetastet. Die Ergebnisse der Abtastung sind als (Amplituden-) Information in den einzelnen Sekundärelektronenimpulsen enthalten. Daher wird der Sekundärelektronenstrom I_{SE} bzw. ein daraus abgeleitetes sekundäres Signal SS registriert. Die Bandbreite des zur Registrierung benutzten Detektionssytems bestimmt daher den minimalen Abstand der Primärelektronenimpulse.

Um nun die einzelnen Sekundärelektronenimpulse eindeutig den zugehörigen Abtastzeitpunkten im Signalverlauf U zuordnen zu können, werden nur die Sekundärelektronenimpulse ausgewertet und zum Meßergebnis weiterverarbeitet, deren zugeordnete Abtastzeitpunkte in einem Zeitfenster mit definierter Länge und definiertem Abstand t_{D}′ vom Triggerimpuls liegen. Dazu wird ausgehend vom Triggersignal Tr ein Fenstersignal WS erzeugt das dieses Zeitfenster definiert. Im dargestellten Fall ist das Zeitfenster dadurch gekennzeichnet, daß das Fenstersignal dann logisch 1 ist. Nur Sekundärelektronenimpulse, die durch Primärelektronenimpulse innerhalb dieses Zeitfensters erzeugt wurden, sind relevant und werden ausgewertet. Die übrigen Impulse werden ignoriert. In Fig. 2 sind die zur Auswertung herangezogenen Impulse schraffiert dargestellt. Die Breite des Zeitfensters bestimmt dabei u.a. die erreichbare Zeitauflösung. Um den gesamten Signalverlauf abzutasten, wird das Zeitfenster über den interessierenden Zeitbereich verschoben, d.h. die Verzögerungszeit t_{D}′ wird entsprechend variiert. Die GeschwindigkeIt, mit der dies geschieht, bestimmt dabei die Anzahl der Sekundärelektronenimpulse pro Abtastzeitpunkt, über die bei der Auswertung gemittelt wird, und entscheidet damit über das Signal-Rausch-Verhältnis des Meßergebnisses. Die Bewegung des Zeitfensters kann dabei sowohl stetig als auch scheinbar zufällig in diskreten Schritten erfolgen, wie an späterer Stelle noch erläutert werden wird. Für die Mittelung der Sekundärelektronenimpulse können dabei die dem Fachmann bekannten Mittelungsverfahren, wie sie beispielsweise auch schon bei den Meßverfahren nach dem Stand der Technik eingesetzt werden, benutzt werden.

Der wesentliche Grundgedanke des erfindungsgemäßen Verfahrens besteht also darin, die Erzeugung der Primärelektronenimpulse und damit die Auswahl der Abtastzeitpunkte völlig asynchron zum Triggersignal vorzunehmen, bei der Auswertung aber nur jeweils die Sekundärelektronenimpulse zu berücksichtigen, die aus einem bestimmten durch das Zeitfenster definierten Abtastzeitbereich des zu messenden Signalverlaufs U stammen.

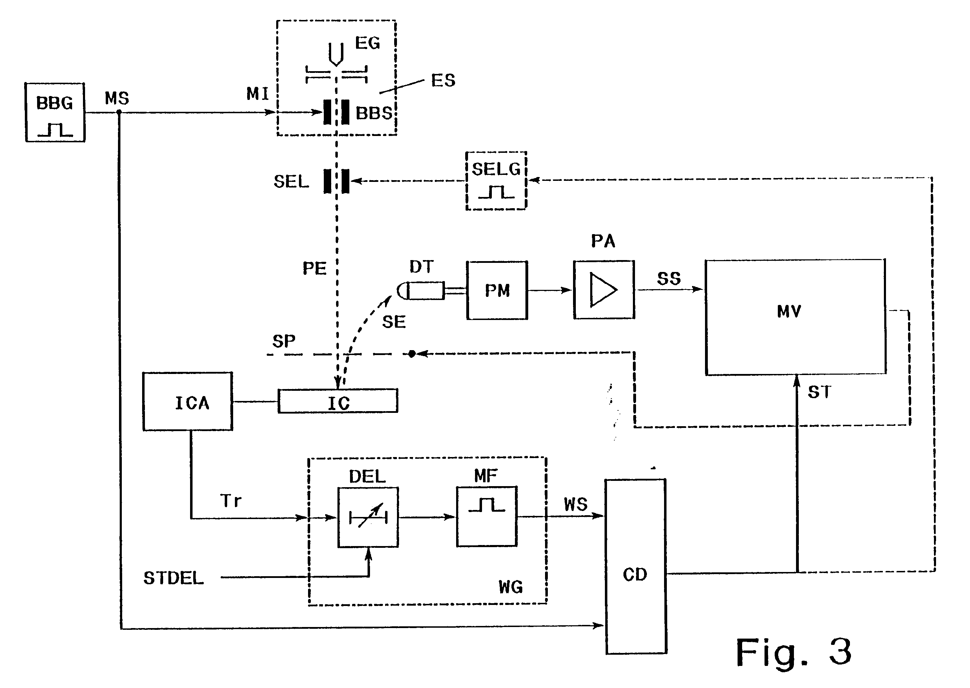

Fig. 3 zeigt schematisch eine Anordnung, mit der das erfindungsgemäße Verfahren realisiert werden kann. Das Kernstück dieser Anordnung bildet ein beispielsweise aus den US-Patentschriften 4220853 und 4223220 bekanntes Elektronenstrahl-Meßgerät. In der elektronenoptischen Säule eines solchen Elektronenstrahl-Meßgerätes wird ein fein gebündelter Primärelektronenstrahl PE erzeugt. Diese elektronenoptische Säule weist neben einer Vielzahl in der Fig. 3 und den späteren Figuren aus Gründen der Übersichtlichkeit nicht dargestellten Blenden und elektrischen oder magnetischen Linsensystemen zur Strahlformung, Strahlablenkung und zur Strahlfokussierung Elektronenquelle ES, die die Primärelektronenimpulse erzeugt, auf.

Die Elektronenquelle ES hat die Aufgabe, die Primärelektronenimpulse zu generieren. In Fig. 3 ist sie aus einer im wesentlichen aus einer Kathode, die die Primärelektronen durch thermische Emission erzeugt, einer Anode und einer Wehnelt-Elektrode bestehenden Elektronenkanone EG und einem Strahlmodulations- oder -austastsystem BBS aufgebaut. Mit Hilfe des Strahlmodulationssystems BBS wird der von der Kathode gelieferte kontinuierliche Primärelektronenstrom in seiner Intensität moduliert. Auf diese Weise können Primärelektronenimpulse erzeugt werden. Mögliche Ausführungsformen von Elektronenkanone EG und Strahlmodulationssystem BBS sind beispielsweise in der Veröffentlichung "Electron beam chopping systems in the SEM" von E. Menzel und E. Kubalek (Scanning Electron Microscopy, SEM Inc., AMF O'Hare, 1979/I, Seiten 305-317) beschrieben.

Zur Erzeugung der Primärelektronenimpulse ist ein Strahlmodulationsgenerator BBG mit dem Modulationseingang MI der Elektronenquelle ES verbunden. Der Strahlmodulationsgenerator BBG steuert das Strahlmodulationssystem BBS mit einem Modulationssignal MS an. In dieser Realisierung besteht das Modulationssignal MS aus Rechteckimpulsen, die mit konstanter Wiederholfrequenz auftreten. Andere Möglichkeiten zur Ansteuerung des Strahlmodulationssystems mit unterschiedlichen Signalformen sind ebenfalls in der zitierten Veröffentlichung von E. Menzel und E. Kubalek beschrieben und könnten im Prinzip ebenfalls verwendet werden. Jeder Rechteckimpuls des Modulationssignals MS tastet den Primärelektronenstrahl PE kurz ein und erzeugt so einen Primärelektronenimpuls. Die Breite der Rechteckimpulse bestimmt dabei die Dauer der Primärelektronenimpulse.

Die so erzeugten Primärelektronenimpulse werden dann durch die in Fig. 3 nicht dargestellten Linsensysteme auf die Probe IC, beispielsweise eine integrierte Schaltung, fokussiert. Dort lösen die auftreffenden Primärelektronen PE Sekundärelektronen SE aus, die vom Detektor DT registriert und in Lichtimpulse umgewandelt werden. Diese Lichtimpulse werden dann über einen Lichtleiter zu dem gewöhnlich außerhalb der Probenkammer des Elektronenstrahlmeßgerätes befindlichen Photomultiplier PM geleitet, der die Lichtimpulse wieder in ein elektrisches Signal umsetzt, das dann, gegebenenfalls nach weiterer Verstärkung in einem dem Photomultiplier PM nachgeschalteten Vorverstärker PA, als (in diesem Fall elektrisches) sekundäres Signal SS zur weiteren Auswertung in einer Meßwertverarbeitungsanordnung MV zur Verfügung steht. Da die Sekundärelektronen SE durch das elektrische Potential am Meßort beeinflußt werden, wird auch das sekundäre Signal SS durch das Potential am Meßort und damit durch den zu messenden Spannungsverlauf U bestimmt.

Die zu untersuchende Probe IC wird zur Reproduktion des interessierenden Vorgangs, z.B. eines Fehlers, zyklisch betrieben. Dazu wird die Probe IC von einer Ansteuerung ICA mit Versorgungsspannungen und gegebenenfalls Eingangssignalen zur Stimulation versorgt. Als Ansteuerung ICA kann dabei insbesondere ein Funktionstester dienen, der dann auch die Ausgangssignale der Schaltung überwacht und dadurch feststellen kann, ob die Probe IC fehlerhaft arbeitet oder nicht. Die Ansteuerung oder die Probe selbst liefert auch das Triggersignal Tr, das anzeigt, daß der zu untersuchende Vorgang in der Probe abläuft bzw. abgelaufen ist. Beipielsweise kann die Ansteuerung ICA jeweils den Beginn eines Testzyklus durch einen Triggerimpuls anzeigen.

Aus dem Triggersignal Tr wird dann mit Hilfe eines Fenstergenerators WG das Fenstersignal WS gewonnen. Als Fenstergenerator kann beispielsweise ein Boxcar-Integrator, insbesondere das Modell 163 der Firma Princeton Applied Research, Verwendung finden. In diesem Fall wird das Triggersignal Tr dem Triggereingang des Boxcar-Integrators zugeführt und das Fenstersignal WS an dem Ausgang des Boxcar-Integrators abgegriffen, der das Öffnen bzw. Schließen des Boxcar-Gates anzeigt. Eine andere bevorzugte Ausgestaltung des Fenstergenerators WG ist in Fig. 3 dargestellt. Dabei besteht der Fenstergenerator WG aus einem steuerbaren Verzögerungsglied DEL und einem diesem nachgeschalteten Monoflop MF. Der Eingang des Verzögerungsgliedes DEL bildet zugleich den Eingang des Fenstergenerators WG und ihm wird das Triggersignal Tr zugeführt. Zu diesem Zweck ist der Eingang des Verzögerungsgliedes DEL mit dem entsprechenden Ausgang der IC-Ansteuerung ICA bzw. der Probe IC verbunden. Durch das Verzögerungsglied DEL wird ein am Eingang des Fenstergenerators WG eintreffender Triggerimpuls um die Zeit t_{D}′ verzögert. Der so verzögerte Triggerimpuls erscheint am Ausgang des Verzögerungsgliedes DEL, der mit dem Eingang des Monoflops MF verbunden ist. Das Monoflop MF wird seinerseits durch den verzögerten Triggerimpuls getriggert und gibt daraufhin an seinem Ausgang einen Rechteckimpuls ab, dessen Breite durch die Einstellung des Monoflops bestimmt ist. Das Ausgangssignal des Monoflops ist somit das gewünschte Fenstersignal WS, und der Ausgang des Monoflops MF stellt zugleich den Ausgang des Fenstergenerators WG dar. Für die Durchführung der Messung muß in bekannter Weise die Verzögerungszeit t_{D}′ variiert werden. Ein Boxcar-Integrator ist dazu selbstständig in der Lage. Es besteht aber auch die Möglichkeit dem Fenstergenerator WG ein Steuersignal STDEL zuzuführen. In der in Fig. 3 dargestellten Ausgestaltung wird dieses Steuersignal STDEL einem Steuereingang des Verzögerungsgliedes zugeführt. Mögliche Ausführungsformen des Verzögerungsgliedes DEL sind dem Fachmann bekannt. Beispielsweise kann eine motorbetriebene mechanische Verzögerungsleitung in Frage kommen. Das Steuersignal STDEL steuert in diesem Fall die Ankerstellung des Motors. Besonders vorteilhaft kann als Verzögerungsglied auch der digital programmierbare Verzögerungsgenerator AD 9500 der Firma Analog Devices Verwendung finden (siehe Analog Devices (Hrsg.): "Linear Products Databook", Norwood, USA, 1988, Seite 9-41 ff.). Bei diesem Baustein wäre das Steuersignal STDEL ein digitales Datenwort, das etwa von einem Rechner geliefert werden kann.

Das Fenstersignal WS wird einem ersten Eingang eines Koinzidenzdetektors CD zugeführt, der dazu mit dem Ausgang des Fenstergenerators WG verbunden ist. Dem zweiten Eingang des Koinzidenzdetektors wird nun ein Signal zugeführt, das angibt, wann mit einem Primärelektronenimpuls eine Messung durchgeführt wird. Besonders vorteilhaft eignet sich dazu das Modulationssignal MS, das ja die Erzeugung der Primärelektronenimpulse steuert. Der Koinzidenzdetektor stellt fest, wann die Messung mit einem Primärelektronenimpuls gerade in das durch das Fenstersignal definierte Zeitfenster fällt. Aufbau und Wirkungsweise eines Koinzidenzdetektors sind dem Fachmann aus der Literatur bekannt. Eine sehr einfache Realisierung eines Koinzidenzdetektors CD stellt beispielsweise ein UND-Gatter dar. Schnelle Koinzidenzdetektoren können auch durch nichtlineare optische Bauelemente realisiert werden. In diesem Fall sind die Eingangssignale optische Signale, die nur dann ein Durchschalten des nichtlinearen Bauelementes bewirken, wenn sie zusammen eintreffen und dadurch eine besonders große Lichtintensität hervorrufen. Andere Ausführungsformen von Koinzidenzdetektoren sind beispielsweise in den deutschen Patentschriften 2842279 und 3523713 beschrieben. Das Ausgangssignal des Koinzidenzdetektors zeigt also an, welche der Sekundärelektronenimpulse bzw. der Impulse des sekundären Signals SS für eine Auswertung der Messung herangezogen werden können. Um die Auswertung zu steuern, ist der Ausgang des Koinzidenzdetektors mit dem Steuereingang ST der Meßverarbeitungsanordnung MV verbunden.

Die Meßverarbeitungsanordnung MV hat die Aufgabe, aus den Impulsen des sekundären Signals SS diejenigen auszuwählen, die für die Bildung des Meßergebnisses relevant sind und sie gegebenenfalls einer weiteren Verarbeitung zu unterziehen. Diese Verarbeitung wird insbesondere in einer Mittelung über sehr viele Einzelabtastungen zur Verbesserung des Signal-Rausch-Verhältnisses bestehen. Einem ersten Eingang der Meßverarbeitungsanordnung MV, dem Signaleingang, wird dazu das sekundäre Signal SS zugeführt. Der zweite Eingang der Meßverarbeitungsanordnung MV, der Steuereingang ST, ist mit dem Ausgang des Koinzidenzdetektors CD verbunden. Am Ausgang der Meßverarbeitungsanordnung steht das gewünschte Meßsignal zur Verfügung. Dieses kann gegebenenfalls noch weiterverarbeitet und beispielsweise zur Steuerung eines Spektrometers SP herangezogen werden. Wie dies geschehen muß, ist dem Fachmann bekannt, da sich die Meßanordnung in dieser Hinsicht nicht von den herkömmlichen Verfahren der Elektronenstrahlmeßtechnik, wie sie in den eingangs zitierten Publikationen beschrieben sind, unterscheidet. Zur Durchführung der Messung wird in ebenfalls bekannter Weise das Meßsignal in Abhängigkeit von der Verzögerungszeit t_{D}′ aufgezeichnet werden. Beispielsweise kann ein Rechner zunächst über den Steuereingang STDEL die Verzögerungszeit einstellen und dann den zugehörigen Meßwert am Ausgang der Meßverarbeitungsanordnung abgreifen. Dies wird dann für mehrere Werte der Verzögerungszeit t_{D}′ wiederholt. Die Einstellung der Verzögerungszeit kann dabei im Prinzip beliebig, also sowohl kontinuierlich als auch in diskreten Schritten erfolgen. Wesentlich ist nur, daß der gesamte interessierende Zeitbereich überstrichen wird.

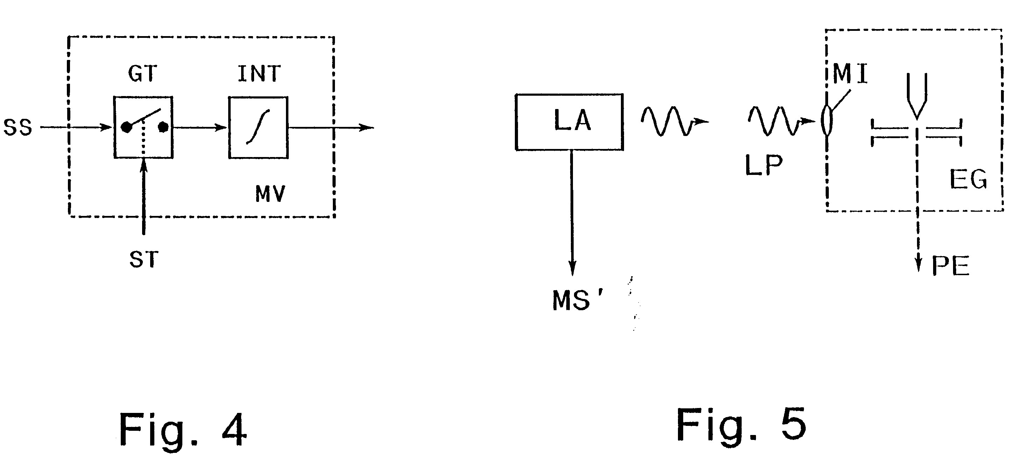

Figur 4 zeigt eine mögliche Ausgestaltung der Meßverarbeitungsanordnung MV. Sie besteht bei dieser Realisierung aus einer eingangsseitigen Torschaltung GT und einem nachgeschalteten Integrator INT. Bei dieser Realisierung bildet ein erster Eingang der Torschaltung GT den Eingang der Meßverarbeitungsanordnung und der Steuereingang wird durch den zweiten Steuereingang der Torschaltung gebildet. Der Ausgang der Torschaltung GT ist mit dem Eingang des Integrators INT verbunden. Die Torschaltung GT schaltet alle Impulse des sekundären Signals, die zu Abtastungen im durch das Fenstersignal WS definierten Zeitfenster gehören, auf den Integrator INT durch, während die übrigen Impulse ignoriert werden. Um welche Impulse es sich dabei handelt, wird durch den Koinzidenzdetektor CD festgestellt und durch dessen Ausgangssignal angezeigt. Darum übernimmt auch das Ausgangssignal des Koinzidenzdetektors CD die Steuerung der Torschaltung GT. Der nachfolgende Integrator INT mittelt über die Abtastwerte aus zahlreichen durch die Primärelektronenimpulse bewirkten Abtastungen des Signalverlaufs U und verbessert dadurch das Signal-Rausch-Verhältnis des Meßergebnisses.

Ordnet man vor der Torschaltung GT eine Speichereinheit, etwa eine durch das Modulationssignal MS gesteuerte Sample&Hold-Schaltung, an, so kann man auch den Signalverlauf vor Erscheinen des Triggerimpulses messen. Besonders vorteilhaft kann die Meßverarbeitungsanordnung mit digitalen Bauelementen realisiert werden. In diesem Fall wird enthält die Meßverarbeitungsanordnung eingangsseitig einen Analog-Digital-Wandler. Speicherung, Durchschalten und Weiterverarbeitung der am Ausgang des Analog-Digital-Wandlers erscheinenden Digitalworte ist mit geringem Aufwand möglich. Die entsprechenden Methoden sind dem Fachmann bekannt. Zur Gewinnung des sekundären Signals SS kann insbesondere ein Energiespektrometer SP in die Anordnung eingebracht werden. Dies ist in Fig. 3 durch ein Gegenfeldnetz angedeutet. Besonders gut eignet sich dazu ein Gegenfeldspektrometer, wie es beispielsweise aus der US-Patentschrift 4292419 bekannt ist. Wie ein solches Spektrometer zur Gewinnung eines Signals benutzt werden kann, ist dem Fachmann bekannt. Eine besonders einfache Möglichkeit ist z.B. das Anlegen einer konstanten Spannung an das Gegenfeldnetz.

Natürlich sind auch andere Ausführungsformen der Elektronenquelle ES als die in Fig. 3 gezeigte möglich. So kann z.B. an Stelle der geheizten Kathode, die durch thermische Emission Primärelektronen PE erzeugt, eine Feldemissionskathode treten. Ebenso ist es möglich, eine Halbleiterkathode zu verwenden. Bei einer Halbleiterkathode kann die Intensität der Emission sehr einfach durch Variation des Kathodenstroms erfolgen. Ein eigenständiges Strahlmodulationssystem BBS hinter der Kathode kann dann entfallen, und das Modulationssignal MS steuert direkt den Kathodenstrom. Ein weiterer möglicher Aufbau der Elektronenquelle ist schematisch in Fig. 5 dargestellt. Hier werden die Primärelektronen PE durch Photoemission aus einer Photokathode erzeugt. Dazu liefert ein Pulslaser LA kurze Lichtimpulse, die über ein in Fig. 5 aus Gründen der Übersichtlichkeit nicht dargestelltes Linsensystem durch ein optisches Fenster MI auf die im Vakuum befindliche Photokathode fokussiert werden und aus der Photokathode durch Photoemission kurze PE-Impulse auslösen. Ein Strahlmodulationssystem BBS kann auch in diesem Fall entfallen, da bereits die Erzeugung der PE moduliert erfolgt. Der Modulationseingang MI ist in diesem Fall kein elektrischer sondern ein optischer Eingang und auch das Modulationssignal MS ist ein optisches Signal, denn es wird durch die vom Laser LA ausgehenden Lichtimpulse gebildet. Ein dazu synchrones elektrisches Signal MS′ kann in diesem Fall dem Koinzidenzdetektor zugeführt werden. Ein solches Signal MS′ kann beispielsweise aus dem Laser LA gewonnen werden. Außerdem ist es möglich, durch einen Teilerspiegel einen Teil der Lichtimpulse des Lasers LA auf eine schnelle Photodiode zu leiten und deren Ausgangssignal, das der Modulation des Signals MS entspricht, als Signal MS′zu benutzen. Allerdings kann es in diesem Fall auch sehr vorteilhaft sein, sowohl den Fenstergenerator als auch den Koinzidenzdetektor optisch zu realisieren. Das steuerbare Verzögerungsglied DEL läßt sich optisch z.B. sehr einfach als variable Wegstrecke, die die Lichtimpulse durchlaufen müssen, realisieren.

Der Aufbau der Elektronenquelle ES wird meist besonders einfach, wenn man die Primärelektronenimpulse mit konstantem Zeitabstand erzeugt, da dann die Modulation des Primärelektronenstrahles PE und das Strahlmodulationssystem BBS fest auf die Wiederholfrequenz der Primärelektronenimpulse bzw. ein Vielfaches oder ein Teil davon abgestimmt werden kann. Dies bedeutet einen erheblichen Vorteil gegenüber den herkömmlichen Verfahren, bei denen das Strahlmodulationssystem sehr breitbandig ausgelegt werden muß. Schmalbandige Systeme weisen aber gewöhnlich eine wesentlich höhere Leistungsfähigkeit auf. So kann man beispielsweise mit einer Art Hohlraumresonator mit konstanter Wiederholfrequenz sehr kurze Primärelektronenimpulse erzeugen. Ein solches System ist u.a. in der zuvor zitierten Veröffentlichung von E. Menzel und E. Kubalek beschrieben. Auch wenn man ein herkömmliches, aus einem Plattenkondensator mit nachfolgender Austastapertur bestehendes, Strahlmodulationssystem benutzt, kann man die schmalbandige Ansteuerung des Strahlmodulationssystems BBS ausnutzen, indem man diesen Kondensator mit einer zusätzlichen Spule versieht und den dadurch entstehenden Resonanzkreis auf die gewünschte Frequenz abstimmt. Ein solches System kann sehr einfach mit einem Sinussignal bei der Resonanzfrequenz angesteuert werden. Die Spannungsüberhöhung im Resonanzkreis sorgt dann für eine besonders hohe Austastempfindlichkeit und ermöglicht auch die Erzeugung sehr kurzer Primärelektronenimpulse, deren Dauer durch die Amplitude der angelegten Sinusspannung bestimmt werden kann.

Manchmal vertragen die zu untersuchenden Proben IC nur eine geringe Belastung durch den Primärstrahl PE. Bei solchen Proben sollte daher die Anzahl der auf der Probe eintreffenden Primärelektronenimpulse möglichst klein gehalten werden. Dazu kann die Erzeugung der Primärelektronenimpulse oder ihre Weiterleitung zur Probe IC auf ein wählbares Zeitfenster, dessen Lage in Bezug auf das Triggersignal Tr definiert wird, beschränkt werden. Praktisch kann man dies einfach dadurch erreichen, daß man eine Torschaltung vor dem Modulationseingang MI anordnet, die das Modulationssignal sperren kann. Bei der Anordnung von Fig. 3 kommt dafür beispielsweise ein PIN-Dioden-Schalter, bei der Anordnung aus Fig. 5 eine Pockelszelle in Betracht. Falls der Strahlmodulationsgenerator BBG über eine "Gated"-Betriebsart verfügen, kann man auch den Gate-Eingang des Generators anstelle einer zusätzlichen Torschaltung ansteuern. Interessiert man sich beispielsweise nur für den Spannungsverlauf U nach dem Triggersignal, so kann man über eine durch das Triggersignal Tr getriggerte Monoflop-Schaltung die Torschaltung bzw. den Strahlmodulationsgenerator BBG nur für diesen interessierenden Zeitraum freischalten. Will man aber auch Vorgänge vor dem Triggerereignis messen, so läßt sich dies nicht anwenden. Weiß man aber, daß der zu messende Signalverlauf U nur mit einer maximalen Wiederholfrequenz auftreten kann, so kann man, wiederum getriggert durch das Triggersignal Tr die Torschaltung bzw. den Strahlmodulationsgenerator BBG für eine gewisse Zeitspanne (die natürlich kleiner als die minimale Periodendauer des zu messenden Signalverlaufs U sein sollte) nach dem Eintreffen eines Triggerimpulses sperren und dadurch eine unnötige Probenbelastung vermeiden.

Ein Nachteil der zuvor beschriebenen Ausgestaltung des erfindungsgemäßen Verfahrens ist die u.U. etwas niedrige effektive Meßrate, da nur ein kleiner Teil der Zyklen des zu messenden Signalverlaufs U tatsächlich zur Bildung des Meßergebnisses herangezogen werden kann. Die Meßrate kann aber erhöht werden, indem man pro festgestellter Koinzidenz von einer Abtastung durch einen Primärelektronenimpuls und dem durch das Fenstersignal WS definierten Zeitfenster nicht nur eine einzelne sondern N Messungen durchführt. Dazu ist es erforderlich, jeweils N Werte des Sekundärelektronenstroms I_{SE} bzw. des sekundären Signals SS pro Koinzidenz getrennt zu erfassen. Voraussetzung für eine korrekte Zuordnung der erfaßten Werte zu Abtastpunkten auf dem Signalverlauf U ist aber, daß die zeitlichen Abstände der Primärelektronenimpulse bekannt sind. Im einfachsten Fall der zeitlich äquidistanten Primärelektronenimpulse ist dies gegeben und im folgenden soll von diesem Fall ausgegangen werden. Die zusätzlich erfaßten und ausgewerteten Werte des Sekundärelektronenstroms bzw. des sekundären Signals (SS) können dabei beliebig vor (Pretrigger) oder hinter (Posttrigger) dem Triggersignal Tr bzw. dem Fenstersignal WS liegen. In Fig. 2 sind die entsprechenden Impulse für N=3 und den Pretrigger-Fall schrafffiert dargestellt. Die Verzögerungszeit t_{D}′ braucht dann nur noch den N-ten Teil des gesamten interessierenden Zeitbereichs zu überstreichen. Soll also die gesamte Periodendauer T gemessen werden, so muß t_{D}′ nun nur noch zwischen t_{D}′ =0 und t_{D}′=T/N variiert werden, da dann beispielsweise der jeweils erste bei einer Koinzidenz registrierte Wert des sekundären Signals SS im Bereich zwischen 0 und T/N liegt, der folgende den Bereich T/N bis 2T/N überstreicht und der i-te Wert schließlich das zu messende Signal im Bereich (i-1)T/N bis iT/N repräsentiert. Aus den so erfaßten und gegebenenfalls zur Verbesserung des Signal-Rausch-Verhältnisses über mehrere Meßzyklen gemittelten Werten des sekundären Signals SS kann dann problemlos die Meßkurve rekonstruiert werden, indem die Meßwerte aus den einzelnen Teilbereichen in korrekter zeitlicher Folge aneinandergesetzt werden.

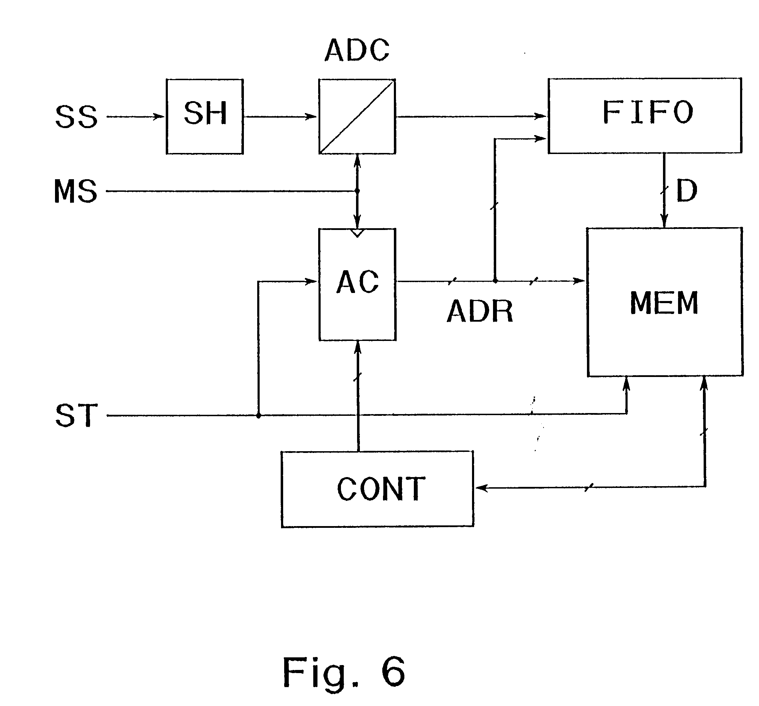

Eine für diese Ausgestaltung des Verfahrens, die im folgenden Multisampling-Variante genannt wird, geeignete Meßverarbeitungsanordnung MV zeigt Fig. 6. Die Meßverarbeitungsanordnung enthält eine Sample&Hold-Schaltung SH, einen Analog-Digital-Wandler ADC, einen schnellen Speicher FIFO, einen Adresszähler AC sowie eine Speichereinheit MEM. Die Kontrolleinheit CONT kann sowohl Bestandteil der Meßverarbeitungsanordnung MV sein als auch als eigenständige Einheit, etwa in Form des die gesamte Meßanordnung steuernden Kontrollrechners, ausgeführt werden. Der gesamten Meßverarbeitungsanordnung werden das sekundäre Signal SS, das Modulationssignal MS bzw. ein dazu synchrones Signal (z.B. MS′) sowie das Ausgangssignal des Koinzidenzdetektors CD - dieses Signal wird an den Steuereingang ST angelegt - zugeführt. Das sekundäre Signal SS gelangt zum Eingang der Sample&Hold-Stufe SH und wird von dieser jedesmal abgetastet, wenn ein Sekundärelektronenimpuls entsteht. Die zeitliche Steuerung des Abtastvorganges erfolgt über das zum Ausgleich der Elektronenlaufzeiten gegebenenfalls zeitverzögerte Modulationssignal MS, das an den Steuereingang der Sample&Hold-Stufe angelegt wird. Der Ausgang der Sample&Hold-Stufe SH ist mit dem Eingang des Analog-Digital-Wandlers ADC verbunden, der die abgetasteten Werte des sekundären Signals SS in digitale Werte umsetzt. Im einfachsten Fall besteht der Analog-Digital-Wandler ADC nur aus einem schnellen Komparator als 1-Bit-A/D-Wandler. Das Ausgangssignal des Analog-Digital-Wandler ADC wird dann in einen schnellen Speicher FIFO, vorzugsweise einen FIFO-Speicher (First in first out) eingelesen. Die Adressierung der Speicherstellen, in die jeweils eingelesen wird, erfolgt über den Adreßzähler AC. Dazu liefert der Adreßzähler AC das Adreßsignal ADR an den schnellen Speicher FIFO. Als Taktsignal wird dem Adreßzähler das Modulationssignal MS zugeführt. Dadurch werden die abgetasteten Werte des sekundären Signals zyklisch in den schnellen Speicher FIFO eingelesen. Der Steuereingang ST ist mit dem Stopp-Eingang des Adreßzählers AC sowie mit der Speichereinheit MEM verbunden. Sobald der Koinzidenzdetektor CD eine Koinzidenz feststellt, wird der Adreßzähler über diesen Eingang gestoppt, so daß im schnellen Speicher FIFO die letzten N Abtastwerte stehen, die vor der Koinzidenz auftraten (Pretrigger). Alternativ kann man auch den Adreßzähler noch einige Taktzyklen weiterzählen lassen und so auch Meßwerte nach der Koinzidenz erfassen (Posttrigger). Diese Werte werden sodann über die Datenleitung D zur Speichereinheit MEM (wiederum gesteuert über den Steuereingang ST) übertragen. Diese Übertragung selbst kann relativ langsam erfolgen, so daß die Speichereinheit MEM als relativ langsamer und dadurch preiswerter Speicher mit geringer Zugriffsgeschwindigkeit ausgelegt werden kann. Lediglich der kleine (er muß im Prinzip nur N Meßwerte abspeichern) schnelle Speicher FIFO muß, da er mit der Wiederholrate der Primärelektronenimpulse getaktet wird, eine hohe Zugriffsgeschwindigkeit aufweisen.

Zusätzlich hat auch die Kontrolleinheit CONT über Datenleitungen Zugriff auf den Adreßzähler AC und die Speichereinheit MEM. Sie kann dadurch die Meßwerte aus der Speichereinheit MEM auslesen, sie gegebenenfalls mitteln und in der zuvor beschriebenen Weise daraus die Meßkurve rekonstruieren.

Nach einer weiteren Ausgestaltung des erfindungsgemäßen Verfahrens, die als Multikoinzidenz-Variante bezeichnet werden soll, kann die Meßzeit dadurch verkürzt werden, daß man die Wahrscheinlichkeit für das Auftreten einer Koinzidenz erhöht. Dies geschieht, indem man nicht nur ein einziges Fenstersignal WS sondern M Fenstersignale WS1 ... WSM erzeugt, die jeweils um die bekannten Zeiten t₀ ... t_{M-1} (t₀=0) gegeneinander verschoben sind. Dann wird parallel überprüft, ob eine Koinzidenz eines Primärelektronenimpulses mit einem dieser Fenstersignale WS1 ... WSM erfolgt, und der entsprechende Wert des sekundären Signals wird in bekannter Weise erfaßt und abgespeichert. Zugleich wird auch abgespeichert, bei welchem Fenstersignal und damit zu welcher Zeitverzögerung die Koinzidenz auftrat. Mit dieser Angabe kann der jeweilige Meßwert eindeutig einem zeitlichen Abtastpunkt im zu messenden Signalverlauf zugeordnet und die Meßkurve damit gewonnen werden.

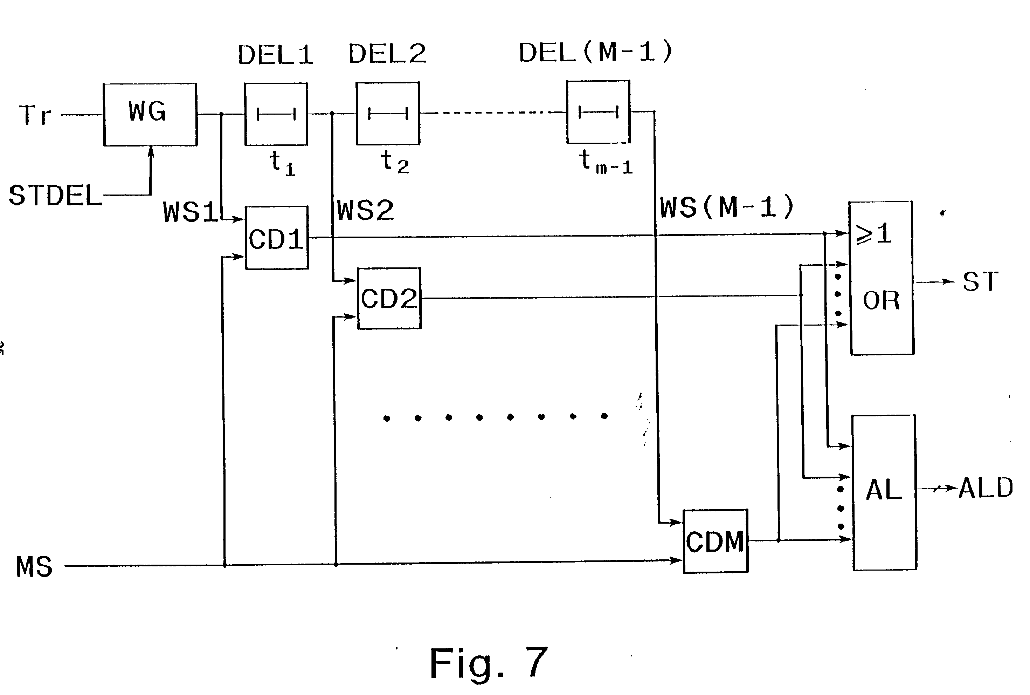

Die für die Multikoinzidenz-Variante erforderliche Erweiterung der Meßanordnung nach Fig. 3 zeigt Fig. 7. Zur Erzeugung der zeitverschobenen Fenstersignale WS1 ... WSM ist hinter dem Fenstergenerator WG eine Kette von hintereinandergeschalteten Verzögerungselementen DEL1 ... DEL(M-1) angebracht, die das Ausgangssignal des Fenstergenerators WG um die Zeiten t₁ ... t_{M-1} verzögern. Die Kette der Verzögerungselemente kann vorteilhaft durch eine Verzögerungsleitung mit äquidistanten Einzelanzapfungen realisiert werden. An den Ausgängen der Verzögerungselemente werden die Fenstersignale WS1 ... WSM abgegriffen und jeweils dem ersten Eingang von M parallelgeschalteten Koinzidenzdetektoren CD1 ... CDM zugeführt. Der zweite Eingang der Koinzidenzdetektoren wird analog zur Realisierung aus Fig. 3 mit dem Modulationssignal MS oder einem dazu synchronen Signal (z.B. MS′) beaufschlagt. Die Ausgänge der Koinzidenzdetektoren CD1 ... CDM sind mit den Eingängen eines ODER-Gatters OR sowie den Eingängen einer Auswahllogik AL verbunden. Das ODER-Gatter erzeugt das Steuersignal ST, das angibt, daß eine Koinzidenz stattgefunden hat. Die Auswahllogik erzeugt ein Datenwort ALD, das angibt, bei welchem Koinzidenzdetektor die Koinzidenz registriert wurde. Dieses Datenwort ALD wird der Speichereinheit MEM zugeführt und dort zusammen mit dem registrierten Meßwert abgespeichert. Diese Speicherung kann dabei so erfolgen, daß das Datenwort ALD als Teiladreßsignal für die Speichereinheit MEM benutzt wird und somit die Position, an der die Meßwerte in der Speichereinheit abgespeichert werden, steuert. Die Gewinnung der Meßkurve ist mit diesen Angaben einfach möglich. Weisen die Verzögerungselemente DEL1 ... DEL(M-1) beispielsweise alle die gleiche Verzögerung t₁ auf und registriert der i-te Koinzidenzdetektor eine Koinzidenz, so entstammt der entsprechende Wert des sekundären Signals SS dem zu messenden Signalverlauf zum Zeitpunkt t_{D}′+(i-1)t₁ bezogen auf das Triggersignal Tr.

Bei dem erfindungsgemäßen Verfahren - und das gilt selbstverständlich für alle Varianten - kommt es nur auf die relative zeitliche Lage zwischen Triggersignal Tr und Primärelektronenstrom I_{PE} an. Daher kann auch das Fenstersignal WS getriggert vom Modulationssignal MS oder einem dazu synchronen Signal (z.B. MS′) erzeugt und dann die Koinzidenz mit einer Flanke des Triggersignals Tr detektiert werden. Dies empfiehlt sich immer dann, wenn die Wiederholrate des Triggersignals höher als die der Primärelektronenimpulse ist. Für die Meßanordnung bedeutet dies, daß der Fenstergenerator WG als Eingangssignal das Modulationssignal MS oder ein dazu synchrones Signal erhält und sein Ausgang statt mit dem ersten mit dem zweiten Eingang des Koinzidenzdetektors CD verbunden wird. An den ersten Eingang des Koinzidenzdetektors wird direkt das Triggersignal Tr angelegt. Als Regel kann man angeben, daß sich der Fenstergenerator WG besonders einfach realisieren läßt, wenn er im niederfrequenteren Eingangszweig des Koinzidenzdetektors liegt.

Bei den bisher beschriebenen Ausgestaltungen des erfindungsgemäßen Verfahrens muß der Sekundärelektronen-Detektor DT die einzelnen Sekundärelektronenimpulse getrennt übertragen. Um eine niedrige Meßzeit zu erreichen, sollte das Detektionssystem daher möglichst schnell sein. Will man aber, etwa aus Kostengründen, ein langsames Detektionssystem, so kann man nach einer weiteren Ausgestaltung des Verfahrens, die als Preselektions-Variante bezeichnet werden soll, die Auswahl der relevanten Meß- bzw. Abtastwerte auch schon im Modulationssignal MS oder im Primärelektronenstrom I_{PE} oder im Sekundärelektronenstrom vornehmen. Dazu wird über eine Selektionseinrichtung SEL das Modulationssignal MS bzw. der Primärelektronenstrahl PE bzw. der Sekundärelektronenstrom I_{SE} gesperrt und erst kurzzeitig freigegeben, nachdem eine Koinzidenz detektiert worden ist. Die Detektion des sekundären Signals kann dann langsam und ebenso wie beim herkömmlichen Verfahren der Waveform-Messung nach dem Stand der Technik erfolgen, da jetzt grundsätzlich nur noch Werte des sekundären Signals entstehen, die auch tatsächlich für das Meßergebnis relevant sind.

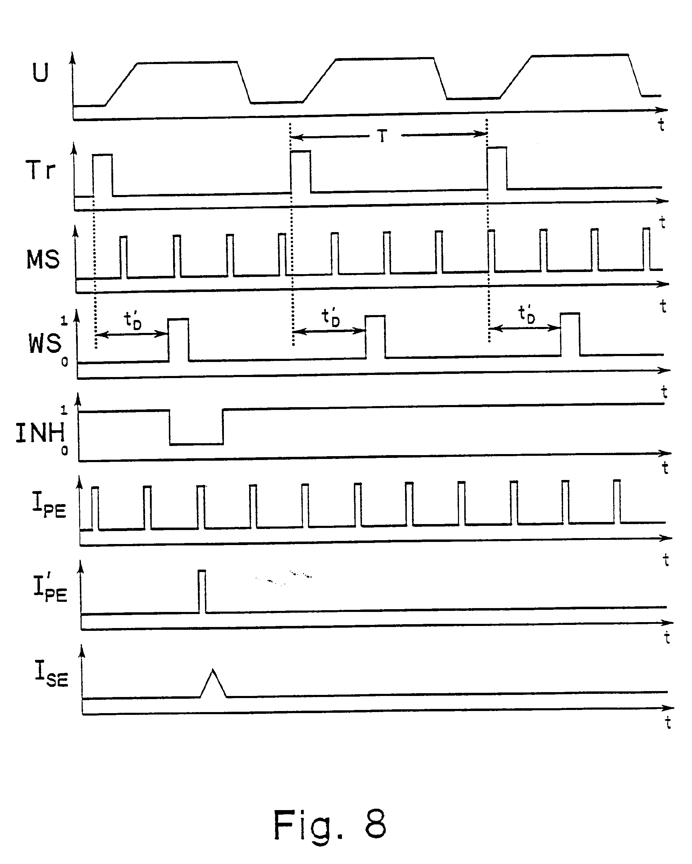

Fig. 8 verdeutlicht diese Ausgestaltung anhand der Vorselektion im Primärstrahl PE. Dargestellt sind die bereits in Fig. 3 dargestellten Signalverläufe des zu messenden Signals U, des Triggersignals Tr, des Fenstersignals WS und des Primärelektronenstroms I_{PE} direkt hinter der Elektronenquelle ES. Zusätzlich ist das Modulationssignal MS dargestellt. Wird eine Koinzidenz zwischen dem Fenstersignal WG und einem Impuls des Modulationssignals MS (das ist auch gleichbedeutend mit einem Primärelektronenimpuls) festgestellt, so wird über ein Selektionssignal INH, das im dargestellten Beispiel dann auf logisch 0 geht, die Selektionseinrichtung SEL freigeschaltet und der der Koinzidenz entsprechende Primärelektronenimpuls gelangt zum Meßpunkt. Der Primärelektronenstrom unmittelbar am Meßpunkt ist mit I_{PE}′ gekennzeichnet. Da die einzelnen Impulse mit relativ großem Abstand aufeinanderfolgen, werden an die Qualität der Selektionseinrichtung SEL keine besonderen Anforderungen gestellt.

Die erforderliche Erweiterung der Meßanordnung für diesen Fall ist in Fig. 3 gestrichelt eingezeichnet. Das Ausgangssignal des Koinzidenzdetektors CD wird dem Eingang des Selektionsgenerators SELG zugeführt, der das Selektionssignal INH erzeugt und an die Selektionseinrichtung SEL, in diesem Fall ein zweites Strahlmodulationssystem, liefert. Setzt man als Strahlmodulationssystem BBS einen Plattenkondensator ein, kann als Selektionseinrichtung SEL auch vorteilhaft die zweite Platte dieses Kondensators (an die erste Platte wird das Modulationssignal angelegt) benutzt werden. Analog kann man auch eine Vorselektion im Modulationssignal MS oder im Sekundärelektronenstrom I_{SE} vornehmen. In der Anordnung nach Fig. 5 beispielsweise kann als Selektionseinrichtung SEL eine zwischen Laser LA und Modulationseingang MI geschaltete Pockelszelle oder ein elektrooptischer Modulator Verwendung finden. Zur Selektion im Sekundärelektronenstrom kann sehr vorteilhaft das Gegenfeldnetz eines Gegenfeldspektrometers benutzt werden, indem man zum Sperren eine starkes Gegenfeld anlegt und dadurch verhindert, daß Sekundärelektronen zum Detektor DT gelangen können. Übrigens kann man auch die Torschaltung GT in Fig. 4 als eine Art Selektionseinrichtung (zur Selektion im sekundären Signal SS). ansehen.

Die zuvor beschriebenen Varianten Multisampling, Multikoinzidenz und Preselektion können nicht nur einzeln sondern auch recht vorteilhaft beliebig kombiniert eingesetzt werden.

Obschon das erfindungsgemäße Verfahren bislang nur für eine Waveform-Messung, bei der der Primärelektronenstrahl nur auf einen einzigen Meßort positioniert wird, beschrieben wurde, läßt es sich prinzipiell bei all den Meßtechniken einsetzen, die ein Stroboskopie- oder Abtastverfahren einsetzen. Im Bereich der Elektronenstrahlmeßtechnik sind hier zum Beispiel die Verfahren "Logic-State Mapping" und "Timing Diagram" zu nennen. Bei diesen Verfahren rastert der Primärstrahl PE über einzelne Punkte, eine Zeile oder einen Teil der Fläche der Probe und ist nicht nur stationär auf einen Punkt gerichtet. Will man das erfindungsgemäße Verfahren auch hier einsetzen, so muß man neben den Meßwerten des sekundären Signals SS auch noch eine Ortsinformation über den Ort, von dem die Meßwerte stammen, aufzeichnen. Wie man eine solche Ortsinformation, etwa in Form der vom Rastergenerator gelieferten Ablenkspannungen, bei einem Elektronenstrahl-Meßgerat gewinnt, ist dem Fachmann bekannt. Bei der Auswertung der Messungen kann dann anhand der gespeicherten Ortsinformation jede Einzelmessung eindeutig einem bestimmten Meßort zugeordnet werden. Auch hier sollte eine Mittelung durchgeführt werden, falls mehrere Meßwerte zum gleichen Zeitpunkt vom gleichen Ort aufgezeichnet wurden. Wie sich bei der Messung der Primärstrahl PE über die Probe bewegt und in welcher Reihenfolge etwa die einzelnen Meßorte abgetastet wurden, ist völlig ohne Bedeutung. Auch braucht die Bewegung des Primärstrahles PE nicht unbedingt an die Messung gekoppelt zu werden. Auch hier lassen sich die üblichen dem Fachmann bekannten Rastertechniken der Elektronenstrahlmeßtechnik einsetzen.

Die Erfindung wurde bisher anhand des Potentialkontrasteffekts in einem Elektronenstrahlmeßgerät beschrieben. Ihre Anwendung ist aber keinesfalls darauf beschränkt. Anstelle der Primär- und Sekundärelektronen können auch beliebige andere Korpuskeln, wie z.B. Ionen, oder eine beliebige Strahlung, insbesondere Lichtstrahlung treten. Verwendet man beispielsweise als Primärstrahl PE einen Laserstrahl, so kann dieser auf der Probenoberfläche Photoelektronen auslösen, die dann aufgrund des Potentialkontrasts von den elektrischen Feldern an der Probenoberfläche beeinflußt werden und, wie zuvor beschrieben, als Sekundärelektronen detektiert werden können. Aber auch andere Wechselwirkungen können anstelle des Potentialkontrasts treten. Dazu zählt beispielsweise die Beeinflussung der von einem Primärelektronenstrahl PE erzeugten Sekundärelektronen SE durch ein magnetisches Feld. Durch Ausnutzung dieses sogenannten "magnetischen Kontrasts" ließe sich etwa die Bewegung magnetischer Domänen in Magnetblasenspeichern untersuchen. Auch braucht das sekundäre Signal SS keineswegs von einem Sekundärkorpuskelstrom herzurühren, der mit Hilfe eines Detektors registriert wird. Ebenso ist es beispielsweise möglich, das sekundäre Signal direkt von der Probe abzuleiten, indem man z.B. den vom Primärstrahl PE in der Probe IC induzierten Strom mißt. Ein Beispiel für eine solche Technik, ist die dem Fachmann wohlbekannte EBIC (Electron beam induced current)-Technik.

Selbstverständlich kann man die verschiedenen Abwandlungen auch kombiniert einsetzen. Verwendet man wiederum einen Laserstrahl als Primärstrahl PE und eine integrierte Schaltung als Probe IC, so kann der Laserstrahl in den pn-Übergängen der Probe IC Elektron-Loch-Paare und damit freie Ladungsträger erzeugen. Dies macht sich dann in einer Änderung der Stromaufnahme der Probe IC bemerkbar. Wie groß diese Änderung ist, hängt auch vom Schaltzustand des jeweiligen pn-Übergangs ab. Eine Änderung des Schaltzustands eines pn-Übergangs ließe sich deshalb leicht durch eine Messung des Versorgungsstroms der Probe IC feststellen. Der Versorgungsstrom der Probe bzw. seine Abweichung vom Ruhestrom kann in diesem Fall unmittelbar als sekundäres Signal SS dienen, ein besonderer Detektor ist nicht erforderlich. Ebenso ist es möglich einen Laserstrahl als Primärstrahl zu benutzen, um das Oberflächenpotential der Probe IC zu messen. Die Wechselwirkungen sind in diesem Fall elektrooptische Effekte. Man bringt dazu einen elektrooptischen Kristall auf die Probenoberfläche auf. Zur Gewinnung des sekundären Signals könnte der Primärstrahl PE auf den elektrooptischen Kristall gerichtet und das reflektierte Licht über einen Polarisator geleitet und einem Detektor, beispielsweise einem Photomultiplier, zugeführt werden. Wenn der elektrooptische Kristall in Abhängigkeit vom Oberflächenpotential der Probe die Polarisationsebene des Lichts dreht, liefert der Photomultiplier an seinem Ausgang ein Signal, dessen Signalhöhe von Oberflächenpotential der Probe abhängt und daher als sekundäres Signal benutzt werden kann.

Die Erfindung ist auch nicht so zu verstehen, daß der Primärstrahl PE fein fokussiert nur die Meßstelle bestrahlt, sondern ebenso ist es im Rahmen der Erfindung möglich, daß er die Probe großflächig bestrahlt und daß die Definition der Meßstelle erst durch eine ortsaufgelöste Gewinnung des sekundären Signals SS erfolgt. Ein Beispiel für eine solche Anwendung ist die Messung von Oberflächenpotentialen mit Photoelektronen mittels des Potentialkontrasts. Dazu kann die Probe auf ihrer ganzen Oberfläche mit Licht bestrahlt werden (der Primärstrahl PE ist also hier sehr stark aufgeweitet) und die entstehenden Photoelektronen SE können dann mit Hilfe eines Vielkanaldetektors nach ihrem Enstehungsort getrennt registriert und zu einem sekundären Signal umgeformt werden. Außerdem ist es möglich, daß die Messung auf der Probe überhaupt nicht ortsaufgelöst erfolgen soll, sondern die Probe selbst zur Meßanordnung gehört und ein an die Probe IC angelegtes Signal U gemessen werden soll.

## Patentansprüche

1. Verfahren zur Messung des zeitlichen Verlaufs eines sich wiederholenden Signals (U) zu wenigstens einem Zeitpunkt an wenigstens einem Meßpunkt einer Probe (IC), wobei die Probe (IC) mit einem Primärstrahl (PE) beaufschlagt wird, der von einzelnen Primärstrahlimpulsen, die Primärkorpuskel- oder Primärstrahlungsimpulse sind, gebildet wird, wobei die Primärstrahlimpulse gesteuert von einem Modulationssignal (MS) erzeugt werden oder wobei die Erzeugung der Primärstrahlimpulse unabhängig von einer externen Steuerung erfolgt, aber ein zu den Primärstrahlimpulsen synchrones Modulationssignal (MS, MS′) zur Verfügung steht, wobei eine Wechselwirkung zwischen Probe (IC) und Primärstrahl (PE) stattfindet, bei der der Primärstrahl (PE) einen Sekundärstrahl bzw. Sekundärstrom (I_{SE}) erzeugt, und wobei von der Probe (IC) ein von dem Sekundärstrahl bzw. Sekundärstrom (I_{SE}) hergeleitetes sekundäres Signal (SS) abgeleitet wird, das von den elektrischen oder magnetischen Potentialen am Meßort auf der Probe (IC) beeinflußt wird, und wobei wenigstens ein Teil der Werte des sekundären Signals (SS) registriert und zu einem Meßwert weiterverarbeitet wird,
**dadurch gekennzeichnet**,
- daß ein den Ablauf des zu untersuchenden Vorgangs in der Probe anzeigendes Triggersignal (Tr) benutzt wird, das in einem definierten zeitlichen Zusammenhang mit dem Verlauf des sich wiederholenden Signals (U) steht,
- daß die einzelnen Primärstrahlimpulse bzw. die Impulse des Modulationssignals (MS, MS′) in beliebigen Zeitabständen aufeinanderfolgen, wobei diese Zeitabstände insbesondere völlig unabhängig vom Verlauf des sich wiederholenden Signals (U) sein dürfen,
- daß die Auswahl, welche Werte des sekundären Signals (SS) zur Bildung des Meßwertes herangezogen werden, so erfolgt, daß nur Werte, die zu Zeitpunkten entstanden, die in einem definierten zeitlichen Zusammenhang mit dem Triggersignal (Tr) und damit auch dem sich wiederholenden Signal (U) standen, zum Meßwert beitragen.

2. Verfahren nach Anspruch 1,
**dadurch gekennzeichnet**, daß die im letzten Verfahrensschritt genannte Auswahl bereits im Modulationssignal oder im Primärstrahl (PE) bzw. bei der Bildung des sekundären Signals (SS) erfolgt.

3. Verfahren nach Anspruch 1,
**dadurch gekennzeichnet**, daß die genannten Verfahrensschritte mehrmals hintereinander durchgeführt werden.

4. Verfahren nach einem der Ansprüche 1 bis 3,
**dadurch gekennzeichnet**, daß der als Auswahlkriterium benutzte zeitliche Zusammenhang durch wenigstens ein Zeitfenster (WS) mit endlicher Breite und einer Verzögerungszeit (t_{D}′) bezogen auf das Triggersignal (Tr) definiert wird und nur solche Werte des sekundären Signals (SS), die zu Zeitpunkten innerhalb des Zeitfensters entstanden, zur Bildung des Meßwertes beitragen.

5. Verfahren nach Anspruch 4,
**dadurch gekennzeichnet**, daß die Verzögerungszeit (t_{D}′) variiert und der Meßwert in Abhängigkeit von der gewählten Verzögerungszeit (t_{D}′) aufgezeichnet wird.

6. Verfahren nach einem der Ansprüche 1 bis 5,
**dadurch gekennzeichnet**, daß die Primärstrahlimpulse mit konstantem zeitlichen Abstand aufeinanderfolgen.

7. Verfahren nach einem der Ansprüche 1 bis 6,
**dadurch gekennzeichnet**, daß das sekundäre Signal (SS) mit Hilfe eines Detektors (DT) von der Probe (IC) abgeleitet wird.

8. Verfahren nach einem der Ansprüche 1 bis 7,
**dadurch gekennzeichnet**, daß das sekundäre Signal (SS) mit Hilfe eines Spektrometers (SP) von der Probe abgeleitet wird.

9. Verfahren nach einem der Ansprüche 1 bis 8,
**dadurch gekennzeichnet**, daß es sich bei der Wechselwirkung zwischen der Probe (IC) und dem Primärstrahl (PE) um die Erzeugung von Sekundärelektronen durch den Primärstrahl (PE) und die nachfolgende Beeinflussung der Sekundärelektronen durch den Potentialkontrast handelt.

10. Verfahren nach einem der Ansprüche 1 bis 8,
**dadurch gekennzeichnet**, daß es sich bei der Wechselwirkung zwischen der Probe (IC) und dem Primärstrahl (PE) um die Erzeugung von Sekundärelektronen durch den Primärstrahl (PE) und die nachfolgende Beeinflussung der Sekundärelektronen durch den magnetischen Kontrast handelt.

11. Verfahren nach einem der Ansprüche 1 bis 8,
**dadurch gekennzeichnet**, daß es sich bei der Wechselwirkung zwischen der Probe (IC) und dem Primärstrahl (PE) um den EBIC-Effekt handelt.

12. Verfahren nach einem der Ansprüche 1 bis 8,
**dadurch gekennzeichnet**, daß es sich bei der Wechselwirkung zwischen der Probe (IC) und dem Primärstrahl (PE) um einen elektrooptischen Effekt handelt.

13. Verfahren nach einem der Ansprüche 1 bis 12,
**dadurch gekennzeichnet**, daß zusätzlich eine Ortsinformation über den Meßort registriert wird.

14. Verfahren nach Anspruch 13,
**dadurch gekennzeichnet,**
- daß der Primärstrahl (PE) über die Probe (IC) bewegt wird und
- daß die Ortsinformation die Position des Primärstrahls (PE) auf der Probe (IC) angibt.

15. Verfahren nach einem der Ansprüche 1 bis 14,
**dadurch gekennzeichnet**, daß mehrere Meßwerte parallel gebildet werden, indem mehrere Auswahlkriterien zur Auswahl der für die Bildung der verschiedenen Meßwerte relevanten Werte des sekundären Signals (SS) bereitgestellt werden.

16. Anordnung zur Messung des zeitlichen Verlaufs eines sich wiederholenden Signals (U) zu wenigstens einem Zeitpunkt an wenigstens einem Meßpunkt einer Probe (IC), wobei die Anordnung eine Primärstrahlquelle (ES) zur Erzeugung eines modulierten Primärstrahls (PE), eine Vorrichtung zur Führung des Primärstrahls (PE) auf die Probe (IC), wobei eine Wechselwirkung zwischen Probe (IC) und Primärstrahl (PE) stattfindet, bei der der Primärstrahl (PE) einen Sekundärstrahl bzw. Sekundärstrom (I_{SE}) erzeugt, eine Vorrichtung zur Ableitung eines von dem Sekundärstrahl bzw. Sekundärstrom (I_{SE}) hergeleiteten sekundären Signals (SS) von der Probe, wobei dieses sekundäre Signal (SS) von den elektrischen oder magnetischen Potentialen am Meßort auf der Probe (IC) beeinflußt wird, eine Einrichtung, die ein den Ablauf des zu untersuchenden Vorgangs in der Probe (IC) anzeigendes Triggersignal erzeugt, und eine Meßverarbeitungsanordnung (MV) zur Speicherung der Werte des sekundären Signals (SS) und zur Weiterverarbeitung dieser Werte zu einem Meßwert enthält,
**gekennzeichnet** durch folgende Merkmale:
- die Anordnung enthält eine Vorrichtung zur Definition wenigstens eines Zeitfensters bezogen auf das in der Probe vorhandene und sich wiederholende Signal (U), die die Meßverarbeitungsanordnung (MV) und/oder eine Selektionseinrichtung (SEL, GT) so steuert, daß zur Bildung des Meßwertes nur solche Werte des sekundären Signals (SS) herangezogen werden, die zu Zeitpunkten innerhalb des definierten Zeitfensters bzw. der definierten Zeitfenster hervorgerufen werden.

17. Anordnung nach Anspruch 16,
**dadurch gekennzeichnet**, daß die Primärstrahlquelle (ES) aus einer Elektronenkanone (EG) zur Erzeugung eines unmodulierten Stroms von Primärkorpuskeln (PE) und einem nachgeschalteten Strahlmodulationsystem (BBS) besteht.

18. Anordnung nach Anspruch 17,
**dadurch gekennzeichnet**, daß das Strahlmodulationssystem bei Resonanz betrieben wird.

19. Anordnung nach Anspruch 16,
**dadurch gekennzeichnet**, daß die Primärstrahlquelle (ES) eine Elektronenkanone (EG) enthält, die bereits selbst einen modulierten Strom von Primärkorpuskeln (PE) erzeugt, und ein zum modulierten Strom von Primärkorpuskeln (PE) synchrones Modulationssignal bereitstellt.

20. Anordnung nach einem der Ansprüch 16 bis 19,
**dadurch gekennzeichnet**, daß die Elektronenkanone (EG) eine Halbleiterkathode enthält, deren Primärkorpuskelemission durch den Strom durch die Kathode gesteuert werden kann.

21. Anordnung nach einem der Ansprüche 16 bis 19,
**dadurch gekennzeichnet**, daß die Elektronenkanone (EG) eine Photokathode enthält, die durch Lichtimpulse (LP) zur Emission von Primärkorpuskelimpulsen angeregt werden kann.

22. Anordnung nach einem der Ansprüche 16 bis 21,
**gekennzeichnet** durch einen Strahlmodulationsgenerator (BBG), der der Primärstrahlquelle (ES) über einen Modulationseingang (MI) ein Modulationssignal (MS) zuführt, durch das eine Modulation des Primärstrahlstroms (I_{PE}) bewirkt wird.

23. Anordnung nach Anspruch 21,
**gekennzeichnet** durch folgende Merkmale:
- der Strahlmodulationsgenerator (BBG) enthält einen Pulslaser (LA),
- das Modulationssignal (MS) besteht aus einzelnen Lichtimpulsen (LP),
- der Modulationseingang (MI) ist ein optischer Eingang.

24. Anordnung nach einem der Ansprüche 16 bis 23,
**dadurch gekennzeichnet**, daß die Vorrichtung zur Definition eines Zeitfensters wenigstens aus einer Verzögerungseinheit (DEL) und einem nachgeschalteten Koinzidenzdetektor (CD) besteht.

25. Anordnung nach Anspruch 24,
**dadurch gekennzeichnet**, daß einem ersten Eingang des Koinzidenzdetektors (CD) die Verzögerungseinheit (DEL), an deren Eingang das Triggersignal (Tr) anliegt, vorgeschaltet ist und daß einem zweiten Eingang des Koinzidenzdetektors (CD) das Modulationssignal (MS) oder ein dazu synchrones Signal (MS′) zugeführt wird.

26. Anordnung nach Anspruch 24,
**dadurch gekennzeichnet**, daß einem ersten Eingang des Koinzidenzdetektors (CD) die Verzögerungseinheit (DEL), an deren Eingang das Modulationssignal (MS) oder ein dazu synchrones Signal (MS′) anliegt, vorgeschaltet ist und daß einem zweiten Eingang des Koinzidenzdetektors (CD) das Triggersignal (Tr) zugeführt wird.

27. Anordnung nach einem der Ansprüche 16 bis 26,
**dadurch gekennzeichnet**, daß die Vorrichtung zur Definition eines Zeitfensters aus mehreren Koinzidenzdetektoren besteht, die mit durch Verzögerungseinheiten (DEL1 ... DEL (M-1)) gegeneinander verschobenen Fenstersignalen (WS1 ... WSM) beaufschlagt werden, wobei die Ausgänge der Koinzidenzdetektoren mit den Eingängen einer ODER-Schaltung (OR) und einer Auswahllogik (AL), die in codierter Form angibt, welcher Koinzidenzdetektor eine Koinzidenz feststellte, verbunden sind.

28. Anordnung nach einem der Ansprüche 24 bis 27,
**dadurch gekennzeichnet**, daß das Ausgangssignal des Koinzidenzdetektors (CD) mit einem Steuereingang der Meßverarbeitungsanordnung (MV) oder einer Selektionseinrichtung (SELG, SEL, GT) zur Selektion des Modulationssigals (MS) oder des Primärstrahls (PE) verbunden ist.

29. Anordnung nach Anspruch 27,
**dadurch gekennzeichnet**, daß das Ausgangssignal der ODER-Schaltung (OR) mit einem Steuereingang der Meßverarbeitungsanordnung (MV) oder einer Selektionseinrichtung (SELG, SEL, GT) zur Selektion des Modulationsignals (MS) oder des Primärstrahls (PE) verbunden ist.

30. Anordnung nach einem der Ansprüche 16 bis 29,
**dadurch gekennzeichnet**, daß die Meßverarbeitungsanordnung (MV) einen Analog-Digital-Wandler (ADC) mit einem nachgeschalteten schnellen Speicher (FIFO) sowie einen Adreßzähler (AC), der von einem zum Modulationssignal synchronen Signal (MS,MS′) getaktet wird, enthält, wobei der Ausgang des Adreßzählers mit den Adreßleitungen (ADR) des schnellen Speichers verbunden ist und der Stopp-Eingang des Adreßzählers den Steuereingang (ST) der Meßverarbeitungsanordnung (MV) bildet.

## Claims

1. Method of measuring the course of a repetitive signal (U) versus time at at least one measuring point on a specimen by at least one point of time on a specimen (IC) influenced by a primary beam formed by primary pulses which are individual corpuscular or corpuscular radiation pulses, these primary pulses being generated under control by a modulation signal (MS), or these pulses being formed independently under external contrdl, however with a modulation signal (MS, MS′) being available which is synchronized with said primary pulses, wherein there is an interaction between said specimen (IC) and said primary beam (PE) in the course of which said primary beam (PE) generates a secondary beam or secondary current (I_{SE}), respectively, and wherein a secondary signal (SS) is derived from said specimen (IC), which is in its turn derived from said secondary beam or current, respectively (I_{SE}), which signal (SS) is influenced by the electric or magnetic potentials at the measuring site on said specimen (IC), and wherein at least part of the values of said secondary signal is recorded and further processed so as to obtain a measured value,
**characterized in**
- that a trigger signal (Tr) is employed which indicates the course of the event to be analysed in said specimen and which presents a defined time-based correlation with said course of said repetitive signal (U),
- that said individual primary pulses or said pulses of said modulation signal (MS, MS′), respectively succeed each other at optionally chosen intervals, it being possible that said intervals are entirely independent, in particular, of the course of said repetitive signal (U),
- that the selection of the respective values of said secondary signal (SS), which are considered in the formation of said measured value, is carried out so that those values only contribute to the measured value which have been formed at moments presenting a defined time-based correlation with said trigger signal (Tr) and hence also said repetitive signal (U).

2. Method according to Claim 1,
**characterized in** that said selection mentioned in the last step of process is made as early as in said modulation signal or in said primary beam (PE) or by the time of generation of said secondary signal (SS), respectively.

3. Method according to Claim 1,
**characterized in** that the aforementioned steps of procedure are carried out in succession repetitively.

4. Method according to any of the Claims 1 to 3,
**characterized in** that said defined time-based correlation, which is employed as selection criterion, is defined by at least one time window (WS) having a finite width and a delay (t_{D}′) relative to said trigger signal (Tr), and that those values of said secondary signal (SS) only, which have been formed at moments within said time window, contribute to the formation of said measured value.

5. Method according to Claim 4,
**characterized in** that said delay interval (T_{D}′) varies and that a measured value is recorded as a function of the chosen delay (t_{D}′).

6. Method according to any of the Claims 1 to 5,
**characterized in** that said primary pulses follow each other at constant intervals.

7. Method according to any of the Claims 1 to 6,
**characterized in** that said secondary signal (SS) is derived from the specimen by means of a detector.

8. Method according to any of the Claims 1 to 6,
**characterized in** that said secondary signal (SS) is derived from the specimen by means of a spectrometer (SP).

9. Method according to any of the Claims 1 to 8,
**characterized in** that the interaction between said specimen (IC) and said primary beam (PE) is the formation of secondary electrons by said primary beam (PE), and the subsequent influence by the potential contrast on said secondary electrons.

10. Method according to any of the Claims 1 to 8,
**characterized in** that the interaction between said specimen (IC) and said primary beam (PE) is the formation of secondary electrons by said primary beam (PE) and the subsequent influence produced by the magnetic contrast on said secondary electrons.

11. Method according to any of the Claims 1 to 8,
**characterized in** that the interaction between said specimen (IC) and said primary beam (PE) is the so-called EBIC effect.

12. Method according to any of the Claims 1 to 8,
**characterized in** that the interaction between said specimen (IC) and said primary beam (PE) is an electro-optical effect.

13. Method according to any of the Claims 1 to 12,
**characterized in** that additionally a site information about the measuring site is recorded.

14. Method according to Claim 13,
**characterized in**
- that said said primary beam (PE) is passed over said specimen (IC) and
- that said site information indicates the position of said primary beam (PE) on said specimen (IC).

15. Method according to any of the Claims 1 to 14,
**characterized in that** a plurality of measured values, is formed in parallel, by making several selection criteria available for the selection of those values of said secondary signal (SS) which are relevant for the formation of various measured values.

16. System for measuring the course of a repetitive signal (U) versus time at at least one measuring point on a specimen by at least one point of time on a specimen (IC), comprising a primary radiation source (ES) for generating a modulated primary beam (PE), a device for guiding said primary beam (PE) onto the specimen, with an interaction being established between said specimen and said primary beam (PE) so that said primary beam (PE) generates a secondary beam or a secondary current (I_{SE}), respectively; as well as a device for deriving a secondary signal from a specimen (IC), which on its part has been derived from said secondary beam or secondary current (I_{SE}), respectively, which secondary signal (SS) is influenced by the electric or magnetic potentials at the measuring site on said specimen (IC); and a measuring value processing system (MV) for storing the values of said secondary signal (SS) and for further treatment of these values so as to obtain a measured value,
**characterized by** the following features:
- the system comprises a device for defining at least one time window relative to said repetitive signal (U) present in the specimen, which device controls said system for processing the measured values (MV) and/or a selection device (SEL, GT) such that for the formation of the measured value only those values of said secondary signal (SS) are employed which are provoked at moments coming within said defined time window or within said defined time windows, respectively.

17. System according to Claim 16,
**characterized in** that said primary radiation source (ES) is composed of an electron gun (EG) for generating a non-modulated current of primary corpuscles (PE) and a beam modulation system (BBS) disposed at the output side.

18. System according to Claim 17,
**characterized in** that said beam modulation system is operated at resonance.

19. System according to Claim 16,
**characterized in** that said primary radiation source (ES) comprises an electron gun (EG) which generates, in its turn already, a modulated current of primary corpuscles (PE), and which supplies a modulation signal which is synchronized with said modulated current of primary corpuscles (PE).

20. System according to any of the Claims 16 to 19,
**characterized in** that said electron gun (EG) comprises a semiconductor cathode whose emission of primary corpuscles may be controlled by the current flowing through the cathode.

21. System according to any of the Claims 16 to 19,
**characterized in** that said electron gun (EG) comprises a phatocathode adapted to be excited by the light pulses (LP) so as to emit primary corpuscular pulses.

22. System according to any of the Claims 16 to 21,
**characterized by** a beam modulating generator (BBG) which supplies a modulation signal (MS) via a modulation input (MI) to said primary radiation source (ES), thus causing a modulation of said primary radiation current (I_{PE}).

23. System according to Claim 21,
**characterized by** the following features:
- said beam modulation generator (BBG) comprises a pulsed laser (LA),
- said modulation signal (MS) is composed by light pulses (LP),
- said modulation input (MI) is an optical input.

24. System according to any of the Claims 16 to 23,
**characterized in** that said device for defining a time window consists of at least one delaying unit (DEL) and a coincidence detector (CD) connected at the output side.

25. System according to Claim 24,
**characterized in** that said delaying unit (DEL), where said trigger signal (Tr) is applied at one input thereof, is connected ahead of a first input of said coincidence detector (CD), and that said modulation signal (MS) or a signal (MS′) synchronized therewith, respectively, is supplied to a second input of said coincidence detector (CD).

26. System according to Claim 24,
**characterized in** that said delaying unit (DEL), where said modulation signal (MS) or a signal synchronized therewith (MS′), respectively, is applied at one input thereof, is connected ahead of a first input of said coincidence detector (CD), and that said trigger signal (Tr) is supplied to a second input of said coincidence detector (CD).

27. System according to any of the Claims 16 to 26,
**characterized in** that said device for defining a time window consists of a plurality of coincidence detectors to which are applied window signals (WS1 ... WSM) which are shifted relative to each other by means of said delaying units (DEL1 ... DEL(M-1)), with the outputs of said coincidence detectors being connected to the inputs of an OR circuit (OR) or a logic selection element (AL) which indicates, in coded form, the respective coincidence detector which has detected coincidence.

28. System according to any of the Claims 24 to 27,
**characterized in** that the output signal from said coincidence detector (CD) is connected to a control input of said system for processing measured values (MV) or a selection device (SELG, SEL, GT) for selecting said modulation signal (MS) or said primary beam (PE).

29. System according to Claim 17,
**characterized in** that the output signal from said OR circuit (OR) is connected to a control input of said system for processing measured values (MV) or a selection device (SELG, SEL, GT) for selecting said modulation signal (MS) or said primary beam (PE).

30. System according to any of the Claims 16 to 29,
**characterized in** that said system for processing measured values (MV) comprises an analog/digital converter (ADC) having an ultra-high-speed memory (FIFO) at the output side, as well as an address counter (AC) synchronized by a signal (MS, MS′) synchronous with said modulation signal, with the output of said address counter being connected to address lines of said ultrahigh-speed memory and the stop input of said address counter forming the control input (ST) of said system for processing measured values (MV).

## Revendications

1. Procédé à mesurer la loi en fonction du temps d'un signal répétitif (U) à au moins un temps à au moins un point de mesure sur un échantillon (IC) qui est exposé à l'influence d'un faisceau primaire formé par des impulsions primaires, qui sont des impulsions corpusculaires ou de rayonnement corpusculaire individuelles, lesdites impulsions primaires étant engendrées à commande par un signal de modulation (MS), ou lesdites impulsions étant formées indépendamment d'une commande extérieure, mais à un signal de modulation (MS, MS′) disponible qui est synchrone auxdites impulsions primaires, dans lequel il y a une action réciproque entre ledit échantillon (IC) et ledit faisceau primaire (PE), au cours de laquelle ledit faisceau primaire (PE) engendre un faisceau secondaire ou respectivement courant secondaire (I_{SE}), et dans lequel on dérive, dudit échantillon (IC), un signal secondaire (SS), dérivé, lui-même, dudit faisceau ou respectivement courant secondaire (I_{SE}, sur lequel signal (SS) prennent de l'influence les potentiels électriques ou magnétiques au lieu de mesure sur ledit échantillon (IC), et dans lequel procédé au moins une partie des valeurs dudit signal secondaire (SS) est enregistrée et traitée ultérieurement afin d'obtenir une valeur mesurée,
**caractérisé en ce**
- qu'un signal de déclenchement (Tr) est utilisé qui signale l'écoulement de l'opération à analyser dans ledit échantillon et qui présente une corrélation définie chronométrée avec la loi dudit signal répétitif (U),
- que lesdites impulsions primaires ou respectivement lesdites impulsions dudit signal de modulation (MS, MS′) individuelles sont successives, l'une après l'autre, aux intervalles choisis à volonté, il étant possible que les lesdits intervalles soient entièrement indépendants, en particulier, de la loi dudit signal répétitif (U),
- que le choix des valeurs particulières dudit signal secondaire (SS), auxquelles on fait appel pour former ladite valeur mesurée, est fait de façon que ces valeurs seulement contribuent à la valeur mesurée, qui étaient formées à des moments qui présentaient une corrélation définie chronométrée audit signal de déclenchement (Tr) et donc aussi audit signal répétitif (U).

2. Procédé selon la revendication 1,
**caractérisé en ce** que ledit choix mentionné dans le dernier pas de procédé est fait déjà dans ledit signal de modulation ou dans le faisceau primaire (PE) ou respectivement quand ledit signal secondaire (SS) est formé.

3. Procédé selon la revendication 1,
**caractérisé en ce** que lesdits pas de procédé mentionnés sont réalisés en succession à plusieurs reprises.

4. Procédé selon une quelconque des revendications 1 à 3,
**caractérisé en ce** que ladite corrélation définie chronométrée, qui est utilisée comme critère de sélection, est définie par au moins une fenêtre de temps (WS) à largeur finie et à une temporisation (t_{D}′) rapportée audit signal d'enclenchement (Tr), et que de telles valeurs dudit signal secondaire (SS) seulement, qui étaient formées aux moments au dedans de ladite fenêtre de temps, contribuent à la formation de la valeur mesurée.

5. Procédé selon la revendication 4,
**caractérisé en ce** que ladite temporisation (t_{D}′) varie et que la valeur mesurée est enregistrée en fonction de la temporisation (t_{D}′) choisie.

6. Procédé selon une quelconque des revendications 1 à 5,
**caractérisé en ce** que lesdites impulsions primaires se suivent à des intervalles constants.

7. Procédé selon une quelconque des revendications 1 à 6,
**caractérisé en ce** que ledit signal secondaire (SS) est dérivé de l'échantillon au moyen d'un détecteur.

8. Procédé selon une quelconque des revendications 1 à 6,
**caractérisé en ce** que ledit signal secondaire (SS) est dérivé de l'échantillon au moyen d'un spectromètre (SP).

9. Procédé selon une quelconque des revendications 1 à 8,
**caractérisé en ce** que l'action réciproque entre l'échantillon (IC) et ledit faisceau primaire (PE) est la formation des électrons secondaires par ledit faisceau primaire (PE), et l'influence ultérieure prise par le contraste en potentiel sur lesdits électrons secondaires.

10. Procédé selon une quelconque des revendications 1 à 8,
**caractérisé en ce** que l'action réciproque entre l'échantillon (IC) et ledit faisceau primaire (PE) est la formation des électrons secondaires par ledit faisceau primaire (PE) et l'influence ultérieure prise par le contraste magnétique sur lesdits électrons secondaires.

11. Procédé selon une quelconque des revendications 1 à 8,
**caractérisé en ce** que l'action réciproque entre l'échantillon (IC) et ledit faisceau primaire (PE) est l'effet dit EBIC.

12. Procédé selon une quelconque des revendccations 1 à 8,
**caractérisé en ce** que l'action réciproque entre l'échantillon (IC) et ledit faisceau primaire (PE) est un effet électro-optique.

13. Procédé selon une quelconque des revendications 1 à 12,
**caractérisé en ce** qu'en plus une information de lieu du lieu de mesure est enregistrée.

14. Procédé selon la revendication 13,
**caractérisé en ce**
- que ledit faisceau primaire (PE) est passé sur l'échantillon (IC), et en ce
- que ladite information de lieu indique la position dudit faisceau primaire (PE) sur l'échantillon (IC).

15. Procédé selon une quelconque des revendications 1 à 14,
**caractérisé en ce** que plusieurs valeurs mesurées sont formées en parallèle, en mettant à disposition plusieurs critères de sélection pour le choix des valeurs dudit signal secondaire (SS), qui sont d'importance pour la formation des diverses valeurs mesurées.

16. Système pour mesurer la loi en fonction du temps d'un signal répétitif (U) à au moins un temps à au moins un point de mesure sur un échantillon (IC), qui comprend une source de rayonnement primaire (ES) pour engendre un faisceau primaire modulé (PE), un dispositif pour guider ledit faisceau primaire (PE) sur l'échantillon, une action réciproque entre l'échantillon et ledit faisceau primaire (PE) étant produite afin que le faisceau primaire (PE) engendre un faisceau secondaire ou respectivement courant secondaire (I_{SE}); ainsi qu'un dispositif pour dériver, d'un échantillon (IC), un signal secondaire dérivé, lui-même, dudit faisceau secondaire ou respectivement courant secondaire (I_{SE}), sur lequel signal secondaire (SS) prennent de l'influence les potentiels électriques ou magnétiques au lieu de mesure sur ledit échantillon (IC); et un système de traitement des valeurs de mesure (MV) pour mémoriser les valeurs dudit signal secondaire (SS) et pour le traitement ultérieur de ces valeurs d'obtenir une valeur mesurée,
**caractérisé par** les attributs suivants:
- le système comprend un dispositif pour la définition d'au moins une fenêtre de temps rapportée audit signal répétitif (U) qui est présent dans l'échantillon, ce dispositif commandant ledit système de traitement des valeurs de mesure (MV) et/ou un dispositif de sélection (SEL, GT) de façon que, pour la formation de la valeur mesurée, de telles valeurs dudit signal secondaire (SS) seulement soient utilisées qui sont provoquées à des moments au dedans de ladite fenêtre de temps définie ou respectivement au dedans desdites fenêtres de temps définies.

17. Système selon la revendication 16,
**caractérisé en ce** que ladite source de rayonnement primaire (ES) est constituée par canon électronique (EG) pour engendre un courant non-modulé de corpuscules primaires (PE) et un système de modulation du faisceau (BBS) placé en aval.

18. Système selon la revendication 17,
**caractérisé en ce** que ledit système de modulation du faisceau est agencé à résonance.

19. Système selon la revendication 16,
**caractérisé en ce** que ladite source de rayonnement primaire (ES) comprend un canon électronique (EG) qui engendre lui-même déjà un courant modulé de corpuscules primaires (PE), et qui met un signal de modulation disponible qui est synchrone audit courant modulé de corpuscules primaires (PE).

20. Système selon une quelconque des revendications 16 à 19,
**caractérisé en ce** que ledit canon électronique (EG) comprend une cathode à semiconducteurs dont l'émission de corpuscules primaires peut être commandé par le courant parcourant la cathode.

21. Système selon une quelconque des revendications 16 à 19,
**caractérisé en ce** que ledit canon électronique (EG) comprend une photocathode apte à être excitée par des impulsions de photons (LP) pour émettre des impulsions de corpuscules primaires.

22. Système selon une quelconque des revendications 16 à 21,
**caractérisé par** un générateur modulateur de faisceau (BBG) qui alimente un signal de modulation (MS) via une entrée de modulation (MI) à ladite source de rayonnement primaire (ES), en donnant lieu à une modulation dudit courant de rayonnement primaire (I_{PE}).

23. Système selon la revendication 21,
**caractérisé par** les attributs suivants:
- ledit générateur modulateur de faisceau (BBG) comprend un laser à impulsions (LA),
- ledit signal de modulation (MS) est composé des impulsions des photons (LP),
- ladite entrée de modulation (MI) est une entrée optique.

24. Système selon une quelconque des revendications 16 à 23,
**caractérisé en ce** que ledit dispositif pour la définition d'une fenêtre de temps est composé au moins d'une unité de temporisation (DEL) et d'un détecteur de coïncidence (CD) placé en aval.

25. Système selon la revendication 24,
**caractérisé en ce** que ladite unité de temporisation (DEL), à une entrée à laquelle est appliqué ledit signal de déclenchement (Tr), est placée en amont d'une première entrée dudit détecteur de coïncidence (CD), et en ce que ledit signal de modulation (MS) ou un signal (MS′) en synchronisé est alimenté à une deuxième entrée dudit détecteur de coïncidence (CD).

26. Système selon la revendication 24,
**caractérisé en ce** que ladite unité de temporisation (DEL), à une entrée à laquelle est appliqué ledit signal de modulation (MS) ou un signal en synchronisé (MS′), est placée en amont d'une première entrée dudit détecteur de coïncidence (CD), et en ce que ledit signal de déclenchement (Tr) est alimenté à une deuxième entrée dudit détecteur de coïncidence (CD).

27. Système selon une quelconque des revendications 16 à 26,
**caractérisé en ce** que ledit dispositif de définition d'une fenêtre de temps est composé d'une pluralité de détecteurs de coïncidence, auxquels sont appliqués des signaux de fenêtre (WS1 ... WSM), qui sont décalé l'un par rapport à l'autre moyennant lesdites unités de temporisation (DEL1 ... DEL(M-1)), les sorties desdits détecteurs de coïncidence étant reliées aux entrées d'un circuit OU (OR) ou d'un élément logique de sélection (AL) qui indique, sous forme codée, le détecteur de coïncidence respectif qui a détecté une coïncidence.

28. Système selon une quelconque des revendications 24 à 27,
**caractérisé en ce** que le signal de sortie dudit détecteur de coïncidence (CD) est relié à une entrée de commande dudit système de traitement des valeurs de mesure (MV) ou d'un dispositif de sélection (SELG, SEL, GT) pour la sélection dudit signal de modulation (MS) ou dudit faisceau primaire (PE).

29. Système selon la revendication 17,
**caractérisé en ce** que le signal de sortie dudit circuit OU (OR) est relié à une entrée de commande dudit système de traitement des valeurs de mesure (MV) ou d'un dispositif de sélection (SELG, SEL, GT) pour la sélection dudit signal de modulation (MS) ou dudit faisceau primaire (PE).

30. Système selon une quelconque des revendications 16 à 29,
**caractérisé en ce** que ledit système de traitement des valeurs de mesure (MV) comprend un convertisseur analogique-numérique (ADC) à une mémoire très rapide placée en aval (FIFO), ainsi qu'un compteur d'adresses (AC) qui est synchronisé par un signal (MS, MS′) synchrone audit signal de modulation, la sortie dudit compteur d'adresses étant reliée aux lignes d'adresses dudit mémoire très rapide et l'entrée d'arrêt dudit compteur d'adresses constituant l'entrée de commande (ST) dudit système de traitement des valeurs de mesure (MV).
